# EUROPEAN PATENT APPLICATION

(11) **EP 4 503 095 A1**
(43) Date of publication of application: **05.02.2025**
(21) Application number: 23774655.7
(22) Date of filing: 13.03.2023
(51) Int. Cl.: H01L 21/304

(54) **CIRCULATION DEVICE AND METHOD FOR CONTROLLING CIRCULATION DEVICE**

(30) Priority: 25.03.2022 JP 2022049252
(71) Applicant: SCREEN Holdings Co., Ltd., Kyoto-shi, Kyoto 602-8585 (JP)
(72) Inventor: IWAO, Michinori, Kyoto-shi, Kyoto 602-8585 (JP)
(74) Representative: Kilian Kilian & Partner mbB
(86) International application number: PCT/JP2023/009698
(87) International publication number: WO 2023/182058

(57) **Abstract**

The present disclosure has an object of providing a technology for efficiently exchanging the remaining treatment liquid. Before a new treatment liquid is filled, the temperature of the treatment liquid remaining in a pipe is increased. The liquid with a high temperature has a lower viscosity, and is easily discharged from the pipe. After the remaining treatment liquid is discharged, the treatment liquid newly stored in a storage tank circulates through an external path.

## Description

### TECHNICAL FIELD

The present disclosure relates to a circulation apparatus and a method of controlling the same.

### BACKGROUND ART

In processes of manufacturing semiconductor devices, surfaces of substrates such as semiconductor wafers are subjected to treatments using chemical solutions. Examples of the treatments include a cleaning treatment. Examples of the chemical solutions (including rinse liquids and organic solvents will be referred to as "treatment liquids") include an acid liquid.

For example, single-wafer substrate treatment equipment that treats substrates one by one rotates the substrate while holding the substrate approximately horizontal and supplies a treatment liquid to the surface of the rotating substrate. The aforementioned treatment is applied in a treatment container generally referred to as a chamber.

The treatment liquid is collected and recycled after being supplied to the substrate. Specifically, the treatment liquid is supplied to the chamber, and the treatment liquid after being subjected to the treatment is collected. Here, a circulation apparatus disposed outside the chamber supplies and collects the treatment liquid.

When a plurality of chambers is prepared, these chambers are stored in respective treatment units. The treatment units are stacked in an approximately vertical direction, and are included in a structure generally referred to as a tower. A plurality of towers may be prepared.

The circulation apparatus supplies and collects the treatment liquid to and from each of the towers. Then, the circulation apparatus supplies and collects the treatment liquid to and from the plurality of chambers for each of the towers.

The circulation apparatus performs not only circulation processes of supplying and collecting the treatment liquid to and from the towers (hereinafter provisionally referred to as "external circulation") but also a circulation process of circulating the treatment liquid inside the circulation apparatus without through the towers (hereinafter provisionally referred to as "internal circulation").

For example, Patent Document 1 below describes the external circulation and the internal circulation on each of the towers. For example, Patent Document 2 below describes use of sulfuric acid as a treatment liquid.

Patent Documents 3, 4, and 5 describe discharging a treatment liquid by its self-weight.

### PRIOR ART DOCUMENT

### PATENT DOCUMENT

Patent Document 1: Japanese Patent Application Laid-Open No. 2021-052038
Patent Document 2: Japanese Patent Application Laid-Open No. 2020-088208
Patent Document 3: Japanese Patent Application Laid-Open No. 2021-174973
Patent Document 4: Japanese Patent No. 5860731
Patent Document 5: Japanese Patent Application Laid-Open No. 2021-44476

### SUMMARY

### PROBLEM TO BE SOLVED BY THE INVENTION

A tree-trunk apparatus includes a storage tank for storing a treatment liquid. The treatment liquid is temporarily stored in the storage tank in both of the external circulation and the internal circulation.

The treatment liquid is exchanged to increase the throughput. Such exchange may also be referred to as "liquid exchange" for convenience. Mainly, the treatment liquid stored in the storage tank is discharged, and a treatment liquid is newly stored in the storage tank in the liquid exchange. The treatment liquid, for example, remaining in a path of the external circulation or the internal circulation besides in the storage tank is also an object to be discharged.

The amount and the temperature (hereinafter also referred to as a "liquid temperature") of the treatment liquid remaining in the path of the external circulation, for example, a tower differ according to circumstances. The same applies to the path of the internal circulation. Discharging the remaining treatment liquid in a duration corresponding to the liquid temperature is preferable to efficiently perform the liquid exchange in correspondence with such circumstances. When the liquid temperature of the treatment liquid is lower, the viscosity of the treatment liquid is higher. When the viscosity of the treatment liquid is higher, it takes a longer time to discharge the treatment liquid.

Before a new treatment liquid is introduced to the circulation apparatus, completion of discharging the treatment liquid remaining in the circulation apparatus is preferable. Thus, one conceivable method is estimating a time from the start to the completion of discharging the remaining treatment liquid (hereinafter also referred to as a "discharge required time") for each temperature of the remaining treatment liquid and introducing a new treatment liquid to the circulation apparatus after a lapse of the discharge required time since the circulation apparatus starts operations for discharge. However, the method requires estimating the discharge required time for each temperature of the remaining treatment liquid in advance.

Without estimating the discharge required time for each temperature in advance, estimating the discharge required time corresponding to an assumed lower limit (for example, a room temperature) of the temperature of the remaining treatment liquid will suffice. The viscosity of the remaining treatment liquid is lower than or equal to that of the remaining treatment liquid at the temperature of the lower limit. After a lapse of the discharge required time corresponding to the lower limit, discharging the remaining treatment liquid is probably completed irrespective of the liquid temperature of the remaining treatment liquid.

However, as the liquid temperature of the remaining treatment liquid is higher than the lower limit, the discharge required time is more excessive. This causes a problem of inefficient liquid exchange.

The present disclosure has been conceived in view of the problem, and has an object of providing a technology for efficiently exchanging the remaining treatment liquid.

### MEANS TO SOLVE THE PROBLEM

A first aspect of a method of controlling a circulation apparatus according to the present disclosure is a method of controlling a circulation apparatus that supplies and collects a liquid to and from an external path. The circulation apparatus includes: a storage tank in which the liquid is an object to be stored; a first pipe including a first inflow end into which the liquid flows from the storage tank, the first pipe being used for supplying the liquid; a first valve connected to the storage tank and controlling discharge of the liquid from the storage tank to an outside of the circulation apparatus; a pump in which the liquid is an object is to be expelled, the pump being disposed in the first pipe and including an inlet connected to the first inflow end and an outlet; a heater in which the liquid is an object is to be heated, the heater being disposed in the first pipe and connected to the outlet; a second pipe including a second outflow end from which the liquid flows into the storage tank, the second pipe being used for collecting the liquid; a second valve disposed in the second pipe and controlling an outflow of the liquid from the second outflow end to the storage tank; a third pipe including a third outflow end from which the liquid flows into the storage tank, the third pipe being a path of the liquid to be stored in the storage tank from a liquid supply source at the outside of the circulation apparatus; a third valve disposed in the third pipe and controlling an outflow of the liquid from the third outflow end to the storage tank; a fourth pipe connected to the second pipe on an opposite side of the second outflow end with respect to the second valve, the fourth pipe being a path of the liquid to be discharged from the second pipe to the outside of the circulation apparatus; and a fourth valve disposed in the fourth pipe and controlling the discharge of the liquid.

The method in the first aspect includes: a first process of closing the first valve, the third valve, and the fourth valve, opening the second valve, driving the heater to increase a temperature of the liquid, and driving the pump, the first process being performed during a first period; a second process of deactivating the pump, opening the first valve, the second valve, and the fourth valve, and closing the third valve, the second process being performed during a second period after the first period; a third process of deactivating the pump, closing the first valve, and opening the third valve, the third process being performed during a third period after the second period; and a fourth process of closing the first valve, the third valve, and the fourth valve, opening the second valve, driving the heater to increase the temperature of the liquid, and driving the pump, the fourth process being performed during a fourth period after the third period.

A second aspect of the method of controlling the circulation apparatus according to the present disclosure is the first aspect. The circulation apparatus in the second aspect further includes: a fifth pipe including a fifth outflow end from which the liquid flows into the storage tank, the fifth pipe being connected to the first pipe on an opposite side of the pump with respect to the heater; a fifth valve disposed in the fifth pipe and controlling an outflow of the liquid from the fifth outflow end to the storage tank; a sixth pipe connected to the fifth pipe on an opposite side of the fifth outflow end with respect to the fifth valve, the sixth pipe being a path of the liquid to be discharged from the fifth pipe to the outside of the circulation apparatus; and a sixth valve disposed in the sixth pipe and controlling the discharge of the liquid.

In the method in the second aspect, the fifth valve and the sixth valve are closed in the first process; the fifth valve and the sixth valve are opened in the second process; and the fifth valve is opened and the sixth valve is closed in the fourth process.

The method in the second aspect further includes a fifth process of closing the first valve, the second valve, the third valve, the fourth valve, and the sixth valve, opening the fifth valve, driving the heater to increase the temperature of the liquid, and driving the pump, the fifth process being performed during a fifth period between the third period and the fourth period.

A third aspect of the method of controlling the circulation apparatus according to the present disclosure is the second aspect. The circulation apparatus in the third aspect further includes: a filter disposed in the first pipe between the heater, and the fifth and sixth pipes; a seventh pipe including a seventh outflow end from which the liquid flows into the storage tank, the seventh pipe being connected to the first pipe between the heater and the filter; a seventh valve disposed in the seventh pipe and controlling an outflow of the liquid from the seventh outflow end to the storage tank; an eighth pipe connected to the seventh pipe on an opposite side of the seventh outflow end with respect to the seventh valve, the eighth pipe being a path of the liquid to be discharged from the seventh pipe to the outside of the circulation apparatus; an eighth valve disposed in the eighth pipe and controlling the discharge of the liquid; a ninth pipe connected to the filter, the ninth pipe being a path of the liquid to be discharged from the filter to the outside of the circulation apparatus; and a ninth valve disposed in the ninth pipe and controlling the discharge of the liquid.

In the method in the third aspect, the seventh valve, the eighth valve, and the ninth valve are closed in the first process; the seventh valve, the eighth valve, and the ninth valve are opened in the second process; and the seventh valve, the eighth valve, and the ninth valve are closed in the fourth process and the fifth process.

The method in the third aspect further includes a sixth process of closing the first valve, the second valve, the third valve, the fourth valve, the fifth valve, the sixth valve, the eighth valve, and the ninth valve, opening the seventh valve, driving the heater to increase the temperature of the liquid lower than or equal to a temperature of the liquid during the fifth period, and driving the pump, the sixth process being performed during a sixth period between the third period and the fifth period.

A fourth aspect of the method of controlling the circulation apparatus according to the present disclosure is the third aspect. The circulation apparatus in the fourth aspect further includes a tenth valve connected to the outlet and controlling the discharge of the liquid to the outside of the circulation apparatus.

In the method in the fourth aspect, the tenth valve is closed in the first process, the second process, the third process, the fourth process, the fifth process, and the sixth process, and the method further includes a seventh process of closing the first valve, the second valve, the third valve, the fourth valve, the fifth valve, the sixth valve, the seventh valve, the eighth valve, and the ninth valve, opening the tenth valve, and driving the pump, the seventh process being performed during a seventh period between the third period and the sixth period.

A first aspect of a circulation apparatus according to the present disclosure is to supply and collect a liquid to and from an external path. The circulation apparatus includes: a storage tank in which the liquid is an object to be stored; a first pipe including a first inflow end into which the liquid flows from the storage tank, the first pipe being used for supplying the liquid; a first valve connected to the storage tank and controlling discharge of the liquid from the storage tank to an outside of the circulation apparatus; a pump in which the liquid is an object is to be expelled, the pump being disposed in the first pipe and including an inlet connected to the first inflow end and an outlet; a heater in which the liquid is an object is to be heated, the heater being disposed in the first pipe and connected to the outlet; a second pipe including a second outflow end from which the liquid flows into the storage tank, the second pipe being used for collecting the liquid; a second valve disposed in the second pipe and controlling an outflow of the liquid from the second outflow end to the storage tank; a third pipe including a third outflow end from which the liquid flows into the storage tank, the third pipe being a path of the liquid to be stored in the storage tank from a liquid supply source at the outside of the circulation apparatus; a third valve disposed in the third pipe and controlling an outflow of the liquid from the third outflow end to the storage tank; a fourth pipe connected to the second pipe on an opposite side of the second outflow end with respect to the second valve, the fourth pipe being a path of the liquid to be discharged from the second pipe to the outside of the circulation apparatus; a fourth valve disposed in the fourth pipe and controlling the discharge of the liquid; and a controller controlling the first valve, the second valve, the third valve, the fourth valve, the pump, and the heater.

During a first period, the controller closes the first valve, the third valve, and the fourth valve, opens the second valve, drives the heater to increase a temperature of the liquid, and drives the pump. During a second period after the first period, the controller deactivates the pump, opens the first valve, the second valve, and the fourth valve, and closes the third valve. During a third period after the second period, the controller deactivates the pump, closes the first valve, and opens the third valve. During a fourth period after the third period, the controller closes the first valve, the third valve, and the fourth valve, opens the second valve, drives the heater to increase the temperature of the liquid, and drives the pump.

A second aspect of the circulation apparatus according to the present disclosure is the first aspect. The circulation apparatus in the second aspect further includes: a fifth pipe including a fifth outflow end from which the liquid flows into the storage tank, the fifth pipe being connected to the first pipe on an opposite side of the pump with respect to the heater; a fifth valve disposed in the fifth pipe and controlling an outflow of the liquid from the fifth outflow end to the storage tank; a sixth pipe connected to the fifth pipe on an opposite side of the fifth outflow end with respect to the fifth valve, the sixth pipe being a path of the liquid to be discharged from the fifth pipe to the outside of the circulation apparatus; and a sixth valve disposed in the sixth pipe and controlling the discharge of the liquid.

The controller in the second aspect closes the fifth valve and the sixth valve during the first period, the controller opens the fifth valve and the sixth valve during the second period. During the fourth period, the controller opens the fifth valve and closes the sixth valve. During a fifth period between the third period and the fourth period, the controller closes the first valve, the second valve, the third valve, the fourth valve, and the sixth valve, opens the fifth valve, drives the heater to increase the temperature of the liquid, and drives the pump.

A third aspect of the circulation apparatus according to the present disclosure is the second aspect. The circulation apparatus in the third aspect further includes: a filter disposed in the first pipe between the heater, and the fifth and sixth pipes; a seventh pipe including a seventh outflow end from which the liquid flows into the storage tank, the seventh pipe being connected to the first pipe between the heater and the filter; a seventh valve disposed in the seventh pipe and controlling an outflow of the liquid from the seventh outflow end to the storage tank; an eighth pipe connected to the seventh pipe on an opposite side of the seventh outflow end with respect to the seventh valve, the eighth pipe being a path of the liquid to be discharged from the seventh pipe to the outside of the circulation apparatus; an eighth valve disposed in the eighth pipe and controlling the discharge of the liquid; a ninth pipe connected to the filter, the ninth pipe being a path of the liquid to be discharged from the filter to the outside of the circulation apparatus; and a ninth valve disposed in the ninth pipe and controlling the discharge of the liquid.

The controller in the third aspect closes the seventh valve, the eighth valve, and the ninth valve during the first period. During the second period, the controller opens the seventh valve, the eighth valve, and the ninth valve. During the fourth period and the fifth period, the controller closes the seventh valve, the eighth valve, and the ninth valve. During a sixth period between the third period and the fifth period, the controller in the third aspect closes the first valve, the second valve, the third valve, the fourth valve, the fifth valve, the sixth valve, the eighth valve, and the ninth valve, opens the seventh valve, drives the heater to increase the temperature of the liquid lower than or equal to a temperature of the liquid during the fifth period, and drives the pump.

A fourth aspect of the circulation apparatus according to the present disclosure is the third aspect. The circulation apparatus in the fourth aspect further includes a tenth valve connected to the outlet and controlling the discharge of the liquid to the outside of the circulation apparatus.

The controller in the fourth aspect closes the tenth valve during the first period, the second period, the third period, the fourth period, the fifth period, and the sixth period. During a seventh period between the third period and the sixth period, the controller in the fourth aspect closes the first valve, the second valve, the third valve, the fourth valve, the fifth valve, the sixth valve, the seventh valve, the eighth valve, and the ninth valve, opens the tenth valve, and drives the pump.

### EFFECTS OF THE INVENTION

The first aspect of the method of controlling the circulation apparatus and the first aspect of the circulation apparatus according to the present disclosure contribute to efficiently discharging the remaining liquid and further improving the efficiency of liquid exchange.

The second aspect of the method of controlling the circulation apparatus and the second aspect of the circulation apparatus according to the present disclosure contribute to reduction of the viscosity of the liquid served to the external circulation and thus smoothly performing the external circulation.

The third aspect of the method of controlling the circulation apparatus and the third aspect of the circulation apparatus according to the present disclosure contribute to smoothly performing the internal circulation.

The fourth aspect of the method of controlling the circulation apparatus and the fourth aspect of the circulation apparatus according to the present disclosure contribute to replacement of the liquid remaining in the pump.

### BRIEF DESCRIPTION OF DRAWINGS

FIG. 1 is a lateral cross-sectional view schematically illustrating substrate treatment equipment.
FIG. 2 is a vertical cross-sectional view schematically illustrating the substrate treatment equipment.
FIG. 3 is a vertical cross-sectional view schematically illustrating a vertical cross-section of the substrate treatment equipment when taken along a line III-III.
FIG. 4 is a side view schematically illustrating an example structure of a left portion of a treatment block viewed in a left direction.
FIG. 5 is a side view schematically illustrating an example structure of a right portion of the treatment block viewed in a right direction.
FIG. 6 is a lateral cross-sectional view schematically illustrating a structure of a treatment unit.
FIG. 7 is a vertical cross-sectional view schematically illustrating the structure of the treatment unit.
FIG. 8 is a block diagram illustrating a functional configuration for controlling operations of each of constituents of the substrate treatment equipment.
FIG. 9 is a block diagram illustrating one example configuration of a controller.
FIG. 10 is a plumbing diagram exemplifying a structure of a circulation apparatus.
FIG. 11 is a diagram exemplifying a structure of an external path outside the circulation apparatus.
FIG. 12 is a block diagram illustrating an outline of functions of a controller.
FIG. 13 is a plumbing diagram exemplifying a structure of the circulation apparatus.
FIG. 14 is a plumbing diagram exemplifying a structure of the circulation apparatus.
FIG. 15 is a plumbing diagram exemplifying a structure of the circulation apparatus.
FIG. 16 is a plumbing diagram exemplifying a structure of the circulation apparatus.
FIG. 17 is a plumbing diagram exemplifying a structure of the circulation apparatus.
FIG. 18 is a plumbing diagram exemplifying a structure of the circulation apparatus.
FIG. 19 is a plumbing diagram exemplifying a structure of the circulation apparatus.
FIG. 20 is a flowchart exemplifying operations of the circulation apparatus.

### DESCRIPTION OF EMBODIMENTS

Embodiments of the present disclosure will be described hereinafter with reference to the attached drawings. The constituent elements described in the embodiments are mere exemplification, and only the exemplification does not intend to limit the scope of the disclosure. The drawings are schematically illustrated. The dimensions and the number of parts in the drawings are illustrated in exaggeration or simplified as appropriate for the sake of easier understanding. The same reference signs are allocated to parts having similar structures and functions in the drawings, and overlapping description will be appropriately omitted.

A right-handed XYZ rectangular coordinate system is employed to illustrate position relationships between the elements in the following description. Specifically, it is assumed that the X-axis and the Y-axis extend in a horizontal direction and the Z-axis extend in a vertical direction (an upward and downward direction). The drawings illustrate a direction in which the arrow point indicates as a positive (plus) direction, and its opposite direction as a negative (minus) direction. Specifically, an upward vertical direction is +Z direction, and a downward vertical direction is -Z direction.

Unless otherwise noted, the expressions indicating relative or absolute positional relationships (e.g., "parallel", "orthogonal", "central") in the DESCRIPTION include those exactly indicating the positional relationships and those where an angle or a distance is relatively changed within tolerance or to the extent that similar functions can be obtained. Unless otherwise noted, the expressions indicating equality between two or more objects (e.g., "same", "equal", and "homogeneous") include those indicating quantitatively exact equality and those in the presence of a difference within tolerance or to the extent that similar functions can be obtained.

Unless otherwise noted, the expressions indicating shapes (e.g., "a rectangular shape" or "a cylindrical shape") include those indicating geometrically exact shapes and those indicating, for example, roughness or a chamfer to the extent that similar advantages can be obtained.

An expression "comprising", "including", "containing", or "having" one constituent element is not an exclusive expression for excluding the presence of the other constituent elements.

Unless otherwise noted, an expression "being coupled" includes a contact state of two elements and a distant state of two elements between which another element is sandwiched.

Unless otherwise noted, "moving" in a direction sometimes includes moving parallel to this direction, and moving in a direction with components identical to those of this direction.

### [1. Structure of substrate treatment equipment]

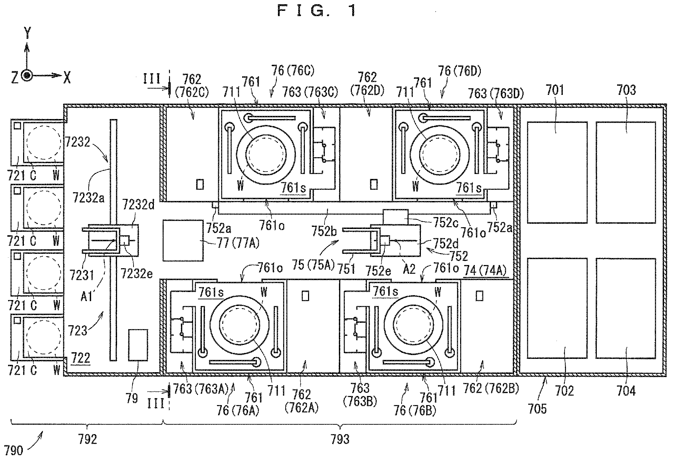

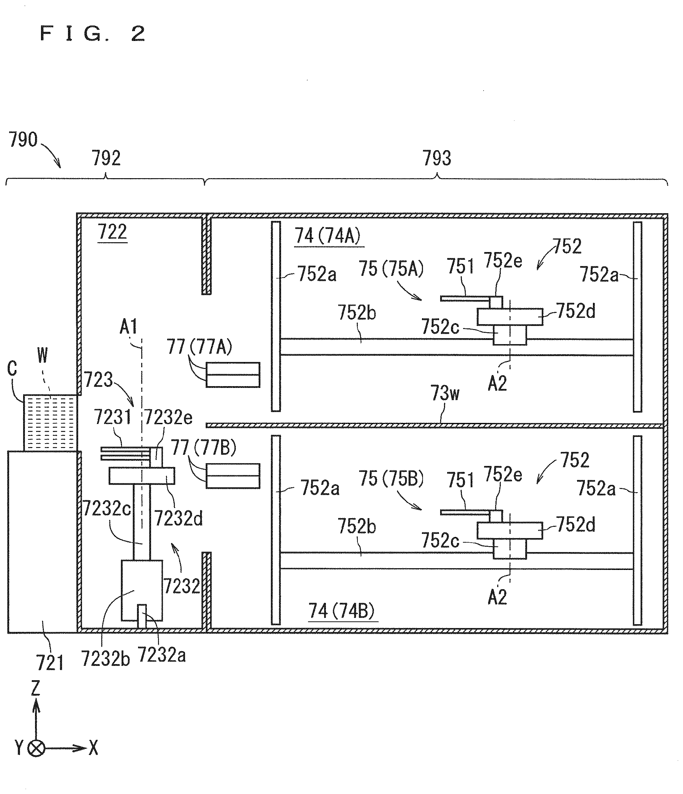

FIG. 1 is a lateral cross-sectional view schematically illustrating substrate treatment equipment 790. FIG. 2 is a vertical cross-sectional view schematically illustrating a vertical cross-section of the substrate treatment equipment 790 along the front and rear direction (±X direction).

The substrate treatment equipment 790 treats a substrate (e.g., a semiconductor wafer) W with a treatment liquid to be supplied and collected to and from a circulation apparatus according to the present disclosure. The circulation apparatus and a method of controlling the same will be described later in detail. The circulation apparatus and the substrate treatment equipment 790 may be collectively understood as a substrate treatment system.

For example, a thin approximately disk-like plate is used as the substrate W. FIG. 1 illustrates, all using broken lines, an outer edge of the substrate W to be stored in each carrier C which will be described later, and an outer edge of the substrate W to be held by each holder 711 which will be described later.

The substrate treatment equipment 790 includes, for example, an indexer 792 and a treatment block 793. The treatment block 793 is coupled to the indexer 792.

The indexer 792 and the treatment block 793 are aligned in a horizontal direction. The indexer 792, for example, supplies the substrates W to the treatment block 793. The treatment block 793, for example, treats the substrates W. The indexer 792, for example, collects the substrates W from the treatment block 793.

In the DESCRIPTION, ±X direction (also referred to as the front and rear direction) is employed for convenience as the horizontal direction in which the indexer 792 and the treatment block 793 are aligned. In the ±X direction (front and rear direction), a direction from the treatment block 793 toward the indexer 792 is employed as -X direction (also referred to as a forward direction or forward), and a direction from the indexer 792 toward the treatment block 793 is to be as +X direction (also referred to as a rear direction or rearward).

A horizontal direction orthogonal to the ±X direction (front and rear direction) is employed as ±Y direction (also referred to as a width direction). In the ±Y direction (width direction), a direction to the right when one faces the -X direction (forward direction) is employed as +Y direction (also referred to as a right direction or right), and a direction to the left when one faces the -X direction (forward direction) is employed as -Y direction (also referred to as a left direction or left).

A direction vertical to the horizontal direction is employed as ±Z direction (also referred to as an upward and downward direction). In the ±Z direction (upward and downward direction), the direction of gravity is employed as -Z direction (also referred to as downward direction or downward), and a direction opposite to the direction of gravity is employed as +Z direction (also referred to as an upward direction or upward). When there is no particular distinction between the front, the rear, the right, and the left, these are all simply referred to as sides.

### [1-1. Structure of indexer]

As illustrated in FIG. 1, the indexer 792 includes a plurality of (e.g., four) carrier placement parts 721, a transport space 722, and at least one (e.g., one) first transport mechanism (also referred to as an indexer mechanism) 723.

The plurality of carrier placement parts 721 are aligned in the width direction (±Y direction). One carrier C is placed on each of the carrier placement parts 721. The carrier C contains a plurality of substrates W. For example, a front opening unified pod (FOUP) is used as the carrier C.

The transport space 722 is located rearward (in the +X direction) of the carrier placement parts 721. The transport space 722 extends in the width direction (±Y direction). The first transport mechanism 723 is located in the transport space 722.

The first transport mechanism 723 is located rearward (in the +X direction) of the carrier placement parts 721. The first transport mechanism 723 transports the substrate W. The first transport mechanism 723 accesses the carrier C placed on each of the carrier placement parts 721.

The first transport mechanism 723 includes a hand 7231 and a hand driving part 7232. The hand 7231 supports the single substrate W in a horizontal orientation. The hand driving part 7232 is coupled to the hand 7231, and moves the hand 7231. Specifically, the hand driving part 7232 moves the hand 7231 in the front and rear direction (±X direction), the width direction (±Y direction), and the upward and downward direction (±Z direction). The hand driving part 7232 includes a plurality of electric motors.

As illustrated in FIGS. 1 and 2, the hand driving part 7232 includes, for example, a rail 7232a, a horizontal mover 7232b, a vertical mover 7232c, a rotator 7232d, and a front and back mover 7232e.

The rail 7232a is fixed to, for example, the bottom of the transport space 722. The rail 7232a extends in the width direction (±Y direction).

The rail 7232a supports the horizontal mover 7232b. The horizontal mover 7232b moves in the width direction (±Y direction) with respect to the rail 7232a.

The horizontal mover 7232b supports the vertical mover 7232c. The vertical mover 7232c moves in the upward and downward direction with respect to the horizontal mover 7232b.

The vertical mover 7232c supports the rotator 7232d. The rotator 7232d rotates relative to the vertical mover 7232c. The rotator 7232d rotates about a rotation axis line A1. The rotation axis line A1 is a virtual line extending in the upward and downward direction.

The front and back mover 7232e moves with respect to the rotator 7232d. The front and back mover 7232e reciprocates in a horizontal direction determined by an orientation of the rotator 7232d. The front and back mover 7232e is connected to the hand 7231.

The hand driving part 7232 implements translating the hand 7231 in the upward and downward direction and in any horizontal direction, and rotationally moving the hand 7231 about the rotation axis line A1.

### [1-2. Structure of treatment block]

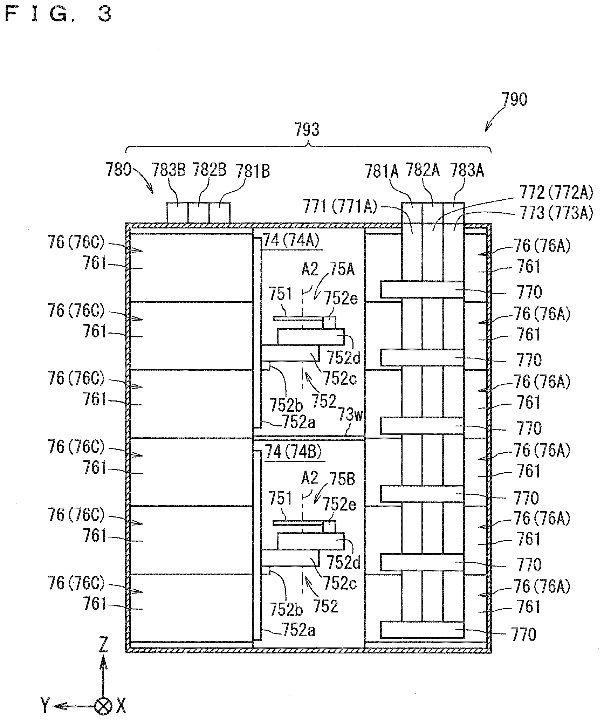

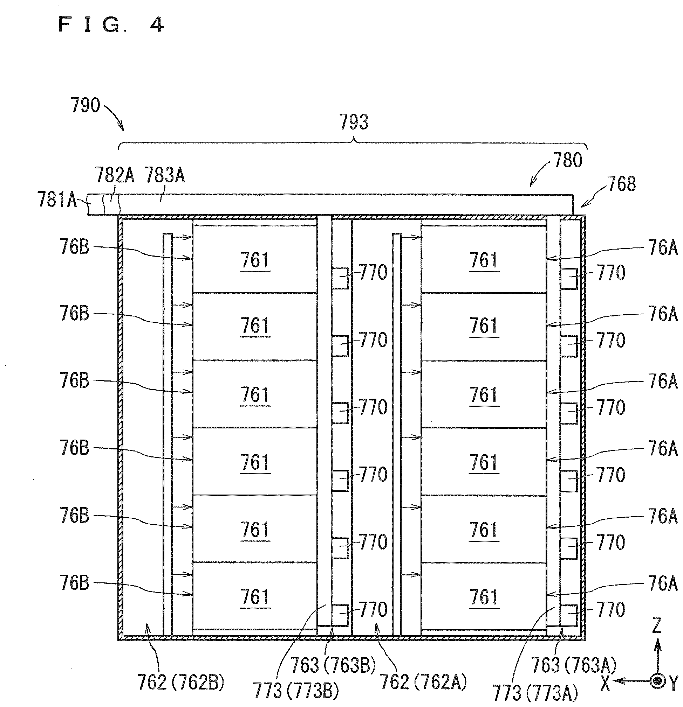

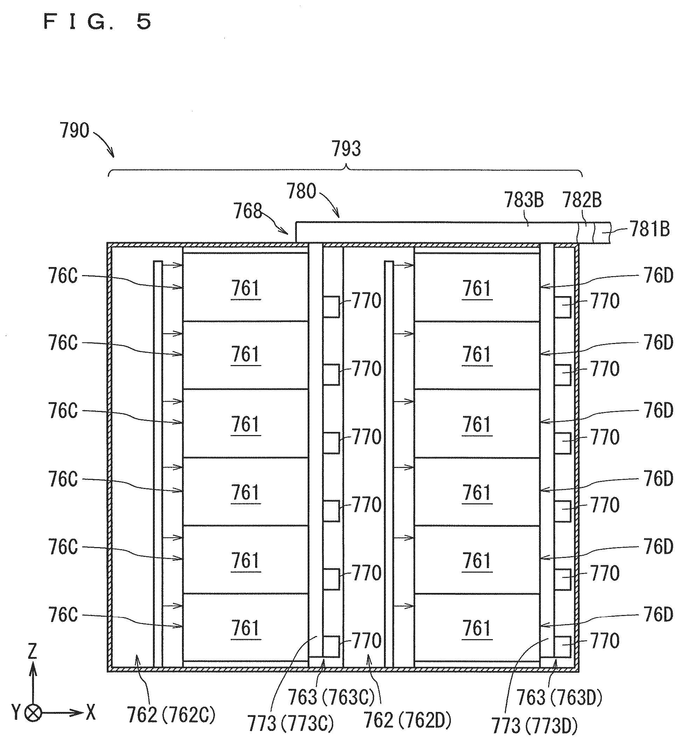

FIG. 3 is a vertical cross-sectional view schematically illustrating a vertical cross-section taken along a line III-III in FIG. 1 when one views the substrate treatment equipment 790 in the rear direction (+X direction). FIG. 4 is a side view schematically illustrating an example structure of a portion in the left (-Y direction; also referred to as a left portion) of the treatment block 793 viewed in the left direction (-Y direction). FIG. 5 is a side view schematically illustrating an example structure of a portion in the right (+Y direction; also referred to as a right portion) of the treatment block 793 viewed in the right direction (+Y direction).

As illustrated in FIGS. 1 to 5, the treatment block 793 includes, for example, two transport spaces 74A and 74B, two second transport mechanisms 75A and 75B, a plurality of (24 herein) treatment units 76, two substrate placement parts 77A and 77B, a partition 73w, and a horizontal exhaust system 780.

The transport space 74A is located in a central portion of the treatment block 793 in the width direction (±Y direction). The transport space 74A extends in the front and rear direction (±X direction). A forward portion of the transport space 74A (also referred to as a front portion) is coupled to the transport space 722 of the indexer 792.

The transport space 74B has a shape approximately identical to that of the transport space 74A. Specifically, the transport space 74B is located in a central portion of the treatment block 793 in the width direction (±Y direction). The transport space 74B extends in the front and rear direction (±X direction). A forward portion of the transport space 74B (also referred to as a front portion) is coupled to the transport space 722 of the indexer 792.

The transport space 74B is located below the transport space 74A. The transport space 74B is positioned to overlap the transport space 74A in a plan view. When there is no distinction between the transport spaces 74A and 74B, these are simply referred to as transport spaces 74.

The partition 73w has, for example, a horizontal plate shape. The partition 73w is located below the transport space 74A, and is located above the transport space 74B. The partition 73w partitions the transport space 74A and the transport space 74B.

The substrate placement part 77A is located in the transport space 74A. The substrate placement part 77A is located in a front portion of the transport space 74A. The first transport mechanism 723 of the indexer 792 also accesses the substrate placement part 77A. One or more of the substrates W are placed on the substrate placement part 77A.

The substrate placement part 77B is located in the transport space 74B. The substrate placement part 77B is located below the substrate placement part 77A. The substrate placement part 77B is located in a front portion of the transport space 74B. The substrate placement part 77B is positioned to overlap the substrate placement part 77A in a plan view. The substrate placement part 77B is located in the same position as the substrate placement part 77A in a plan view.

The first transport mechanism 723 of the indexer 792 also accesses the substrate placement part 77B. One or more of the substrates W are placed on the substrate placement part 77B. When there is no distinction between the substrate placement parts 77A and 77B, these are simply referred to as substrate placement parts 77.

The second transport mechanism 75A is located in the transport space 74A. The second transport mechanism 75A transports the substrates W. The second transport mechanism 75A accesses the substrate placement part 77A.

The second transport mechanism 75B is located in the transport space 74B. The second transport mechanism 75B transports the substrates W. The second transport mechanism 75B has the same structure as that of the second transport mechanism 75A. The second transport mechanism 75B accesses the substrate placement part 77B. When there is no distinction between the second transport mechanisms 75A and 75B, these are simply referred to as second transport mechanisms 75.

Each of the second transport mechanisms 75 includes a hand 751 and a hand driving part 752. The hand 751 supports the single substrate W in a horizontal orientation. The hand driving part 752 is coupled to the hand 751. The hand driving part 752 moves the hand 751 in the front and rear direction (±X direction), the width direction (±Y direction), and the upward and downward direction. The hand driving part 752 includes a plurality of electric motors.

Specifically, the hand driving part 752 includes, for example, two struts 752a, a vertical mover 752b, a horizontal mover 752c, a rotator 752d, and a front and back mover 752e.

The two struts 752a are fixed to, for example, the sides of the transport space 722. The two struts 752a are aligned in the front and rear direction (±X direction). Each of the struts 752a extends in the upward and downward direction.

The two struts 752a support the vertical mover 752b. The vertical mover 752b extends in the front and rear direction (±X direction), and spans between the two struts 752a. The vertical mover 752b moves in the upward and downward direction with respect to the two struts 752a.

The vertical mover 752b supports the horizontal mover 752c. The horizontal mover 752c moves in the front and rear direction (±X direction) with respect to the vertical mover 752b. The horizontal mover 752c moves in the front and rear direction (±X direction) between the two struts 752a.

The horizontal mover 752c supports the rotator 752d. The rotator 752d rotates relative to the horizontal mover 752c. The rotator 752d rotates about a rotation axis line A2. The rotation axis line A2 is a virtual line extending in the upward and downward direction.

The front and back mover 752e moves with respect to the rotator 752d. The front and back mover 752e reciprocates in a horizontal direction determined by an orientation of the rotator 752d. The front and back mover 752e is connected to the hand 751.

The hand driving part 752 implements translating the hand 751 in the upward and downward direction and in any horizontal direction, and rotationally moving the hand 751 about the rotation axis line A2.

Each of the 24 treatment units 76 subjects the substrate W transported by the second transport mechanism 75 to a predetermined treatment.

The treatment block 793 includes six treatment units 76A, six treatment units 76B, six treatment units 76C, and six treatment units 76D. When there is no distinction between the treatment units 76A, 76B, 76C, and 76D, these are simply referred to as the treatment units 76.

The six treatment units 76A are located in a stack manner in the upward and downward direction. In other words, the six treatment units 76A are aligned in a row in the upward and downward direction. The six treatment units 76B are located in a stack manner in the upward and downward direction. In other words, the six treatment units 76B are aligned in a row in the upward and downward direction. The six treatment units 76C are located in a stack manner in the upward and downward direction. In other words, the six treatment units 76C are aligned in a row in the upward and downward direction. The six treatment units 76D are located in a stack manner in the upward and downward direction. In other words, the six treatment units 76D are aligned in a row in the upward and downward direction.

The six treatment units 76A, the six treatment units 76B, the six treatment units 76C, and the six treatment units 76D are included in the aforementioned respective towers (four towers herein).

Six treatment chambers 761 in the six treatment units 76A are stacked in the upward and downward direction. Six treatment chambers 761 in the six treatment units 76B are stacked in the upward and downward direction. Six treatment chambers 761 in the six treatment units 76C are stacked in the upward and downward direction. Six treatment chambers 761 in the six treatment units 76D are stacked in the upward and downward direction.

The six treatment units 76A and the six treatment units 76B are located to the left (-Y direction) of the transport space 74A and the transport space 74B, respectively. The six treatment units 76A and the six treatment units 76B are aligned in the front and rear direction (±X direction) along the transport space 74A and the transport space 74B, respectively. The six treatment units 76B are located rearward (in the +X direction) of the six treatment units 76A.

The six treatment units 76C and the six treatment units 76D are located to the right (+Y direction) of the transport space 74A and the transport space 74B, respectively. The six treatment units 76C and the six treatment units 76D are aligned in the front and rear direction (±X direction) along the transport space 74A and the transport space 74B, respectively. The six treatment units 76D are located rearward (in the +X direction) of the six treatment units 76C.

The six treatment units 76A and the six treatment units 76C face each other across the transport space 74A and the transport space 74B. The six treatment units 76B and the six treatment units 76D face each other across the transport space 74A and the transport space 74B.

The second transport mechanism 75 accesses the holder 711 of the treatment unit 76. The second transport mechanism 75A located above the partition 73w transports the substrates W to upper 12 (4 × upper three tiers) treatment units 76 of the 24 treatment units 76, and transports the substrates W out of these upper 12 treatment units 76. The second transport mechanism 75B located below the partition 73w transports the substrates W to lower 12 (4 × lower three tiers) treatment units 76 of the 24 treatment units 76, and transports the substrates W out of these lower 12 treatment units 76.

### [1-3. Structure of treatment unit]

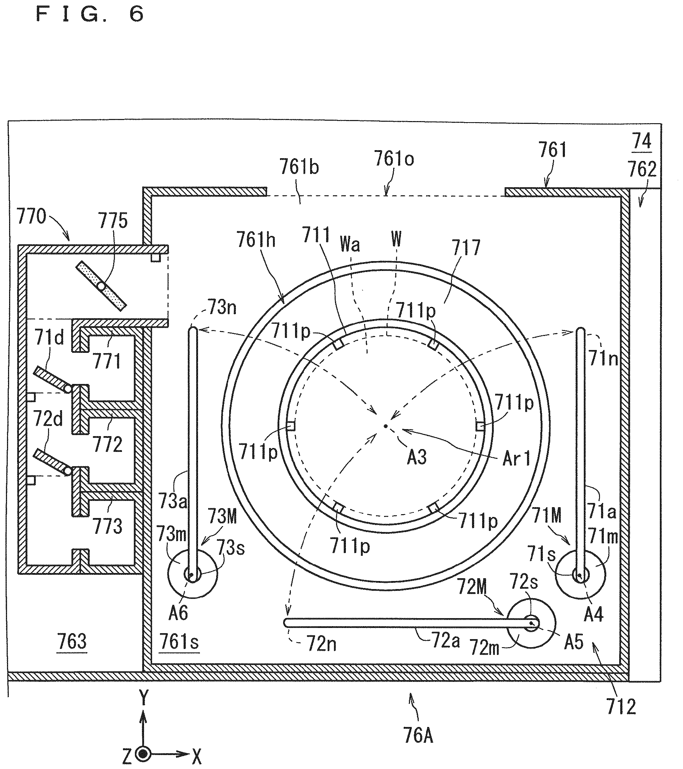

FIG. 6 is a lateral cross-sectional view schematically illustrating a structure of the treatment unit 76, using the treatment unit 76A as an example. Each of the treatment chambers 761 is adjacent to the transport space 74.

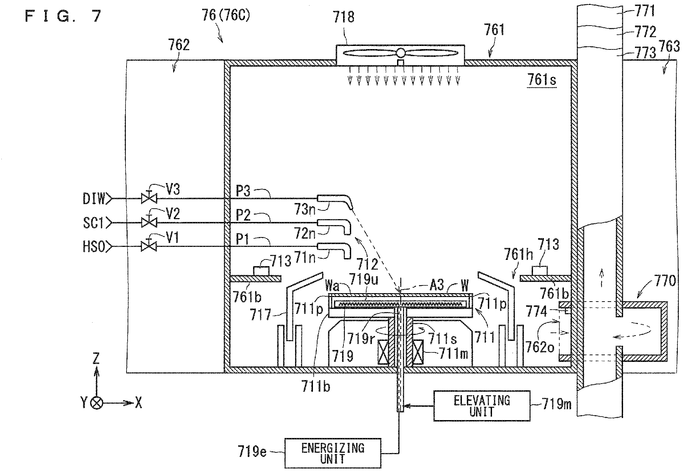

FIG. 7 is a lateral cross-sectional view schematically illustrating the structure of the treatment unit 76, using the treatment unit 76C as an example.

As illustrated in FIGS. 6 and 7, each of the treatment units 76 includes the treatment chamber 761 (also referred to as a chamber or a treatment container), a supply pipe space 762, and an exhaust pipe space 763. For example, the plurality of treatment units 76 have the same structure.

### [1-4. Structure of treatment chamber]

The treatment chamber 761 is, for example, approximately box-shaped. The treatment chamber 761 is of, for example, an approximately rectangular shape in a plan view, a front view, and a side view. The treatment chamber 761 includes a treatment space 761s inside the treatment chamber 761. The treatment unit 76 treats the substrate W in the treatment space 761s. FIG. 6 illustrates, using a broken line, an outer edge of the substrate W held by the holder 711.

The treatment chamber 761 includes a substrate outlet 761o closer to the transport space 74. The substrate outlet 761o is formed in a sidewall of the treatment chamber 761. The substrate outlet 761o is sized to allow the substrate W to pass therethrough. The second transport mechanism 75 transports the substrates W through the substrate outlet 761o between the outside of the treatment chamber 761 (specifically, the transport space 74) and the inside of the treatment chamber 761 (specifically, the treatment space 761s). Each of the treatment units 76 includes a shutter (not illustrated) that opens and closes the substrate outlet 761o.

Each of the treatment units 76 includes, for example, the holder 711 and a fluid supplier 712.

The holder 711 is located inside the treatment chamber 761. The holder 711 holds the substrate W. Specifically, the holder 711 holds the single substrate W in a horizontal orientation. The holder 711 includes, for example, a part (also referred to as a driver) that rotates the substrate W held by this holder 711 about a rotation axis line A3 that is virtual along the vertical direction.

A spin chuck is used as the holder 711. The spin chuck, for example, rotates the substrate W about the rotation axis line A3 passing through a central portion of the substrate W and extending in the upward and downward direction.

Specifically, the spin chuck includes chuck pins (chuck parts) 711p, a spin base 711b, a rotation shaft 711s coupled to the center of the lower surface of the spin base 711b, and an electric motor 711m as a driver that applies a rotational force to the rotation shaft 711s.

The rotation shaft 711s extends along the rotation axis line A3 in the upward and downward direction. The rotation shaft 711s is, for example, a hollow shaft.

The spin base 711b is coupled to the upper end of the rotation shaft 711s. The spin base 711b is disk-shaped in the horizontal direction. The spin base 711b is circular about the rotation axis line A3 in a plan view, and has a diameter larger than that of the substrate W. The plurality of (e.g., six) chuck pins 711p are located at intervals in a circumferential direction in a peripheral portion of the upper surface of the spin base 711b.

The plurality of chuck pins 711p can be opened and closed between a closed state of holding the substrate W in contact with a circumferential edge of the substrate W and an opened state of retracting from the circumferential edge of the substrate W. The plurality of chuck pins 711p, for example, support the substrate W from the bottom while coming in contact with the lower surface of a peripheral portion of the substrate W in the opened state.

For example, a linkage mechanism included in the spin base 711b and a unit including a driving source located outside of the spin base 711b drive opening and closing of the chuck pins 711p. The driving source includes, for example, a ball screw mechanism and an electric motor that applies a driving force to this ball screw mechanism.

Each of the treatment units 76 includes, for example, a heater unit 719. The heater unit 719 is located above the spin base 711b. An elevating axis 719r extending along the rotation axis line A3 in the upward and downward direction is coupled to the lower surface of the heater unit 719.

The elevating axis 719r is inserted into a through hole penetrating a central portion of the spin base 711b in the upward and downward direction and a hollow part of the rotation shaft 711s extending in the upward and downward direction.

The lower end of the elevating axis 719r extends downward over the lower end of the rotation shaft 711s. An elevating unit 719m is coupled to the lower end of the elevating axis 719r. Operating the elevating unit 719m causes the heater unit 719 to move up and down between a down position closer to the upper surface of the spin base 711b and an up position at which the heater unit 719 lifts the substrate W from the chuck pins 711p while supporting the lower surface of the substrate W.

The elevating unit 719m includes, for example, a ball screw mechanism and an electric motor that applies a driving force to this ball screw mechanism. Accordingly, the elevating unit 719m can dispose the heater unit 719 at any middle position between the down position and the up position.

For example, radiant heat from a heating surface 719u, which is the upper surface of the heater unit 719, can heat the substrate W while the heating surface 719u is disposed in a separating position at a predetermined distance from the lower surface of the substrate W. For example, when the heater unit 719 lifts the substrate W, the substrate W is heated with a greater amount of heat in a contact state where the heating surface 719u comes in contact with the lower surface of the substrate W, through thermal conduction from the heating surface 719u.

The heater unit 719 is shaped like a circular hot plate. The heater unit 719 includes a plate body, a plurality of support pins, and a heater. The upper surface of the plate body is a plane along a horizontal plane. The plate body is of a circular shape in a plan view similar to the substrate W, and has a diameter slightly smaller than that of the substrate W.

An outer circumferential edge of the plate body is located inside the plurality of chuck pins 711p. In other words, the plurality of chuck pins 711p surround the plate body in the horizontal direction. This prevents the heater unit 719 from interfering with the chuck pins 711p when the heater unit 719 moves up and down.

The support pins are, for example, respective hemisphere-like pins slightly protruding upward from the upper surface of the plate body. The plurality of support pins are almost equally spaced on the upper surface of the plate body. The plurality of support pins need not be disposed on the upper surface (the heating surface 719u) of the plate body.

For example, when the plurality of substrates W are supported in contact with the support pins, the lower surface of the substrates W faces the upper surface (the heating surface 719u) of the plate body at a minute distance. This enables the heater unit 719 to heat the substrates W efficiently and uniformly.

For example, a resistive body included in the plate body is used as the heater. For example, energizing the heater can heat the upper surface (the heating surface 719u) of the plate body to a temperature higher than boiling points of organic solvents. A feeder to the heater is inserted into the elevating axis 719r. Then, an energizing unit 719e that supplies power to the heater is connected to the feeder.

Each of the treatment units 76 includes, for example, a tubular cup 717 surrounding the holder 711 inside the treatment chamber 761.

The fluid supplier 712 supplies, for example, fluids of a plurality of kinds to the substrates W held by the holder 711. Examples of the fluids of the plurality of kinds include treatment liquids such as chemical solutions, rinse liquids, and organic solvents. Examples of the chemical solutions include etching solutions and cleaning fluids. For example, acidic solutions (acid liquids) and alkaline solutions (alkaline liquids) are used as the chemical solutions.

Examples of the acidic solutions include at least one of fluoric acid (hydrofluoric acid), hydrochloric acid hydrogen peroxide mixture (SC2), sulfuric acid, sulfuric acid hydrogen peroxide mixture (SPM), fluonitric acid (a mixed solution of hydrofluoric acid and nitric acid), or hydrochloric acid.

Examples of the alkaline solutions include at least one of ammonia hydrogen peroxide mixture (SC1), aqueous ammonia, ammonium fluoride solution, or tetramethylammonium hydroxide (TMAH).

The rinse liquids are, for example, liquids for flushing a chemical solution on the substrate W. For example, deionized water (DIW) is used as a rinse liquid.

The organic solvents are, for example, liquids for removing a rinse liquid on the substrate W. For example, isopropyl alcohol (IPA) is used as an organic solvent.

Examples of the plurality of fluids include gas such as inert gas. For example, nitrogen gas is used as the inert gas.

The fluid supplier 712 includes, for example, a first moving nozzle 71n, a second moving nozzle 72n, and a third moving nozzle 73n each of which ejects a predetermined fluid.

A first moving unit 71M moves the first moving nozzle 71n in the horizontal direction. With the movement in the horizontal direction, the first moving nozzle 71n can be moved between a position facing the rotation center of the upper surface Wa of the substrate W held by the holder 711 (hereinafter referred to as a "first ejection position") and a position not facing the upper surface Wa of the substrate W held by the holder 711 (hereinafter referred to as a "first home position").

The first ejection position may be, for example, a position from which the first moving nozzle 71n ejects a first treatment liquid so that the first treatment liquid sits on the rotation center of the upper surface of the substrate W. The first home position is a position outside the holder 711 in a plan view. Specifically, the first home position may be a position outside the cup 717 in a plan view.

The movement of the first moving unit 71M in the upward and downward direction may bring the first moving nozzle 71n closer to the upper surface Wa of the substrate W held by the holder 711, or retract the first moving nozzle 71n upward from the upper surface Wa of the substrate W held by the holder 711.

The first moving unit 71M includes, for example, a first pivot axis 71s extending in the upward and downward direction, a first arm 71a coupled to the first pivot axis 71s and extending horizontally, and a first arm driving mechanism 71m driving the first arm 71a.

The first arm driving mechanism 71m pivots the first arm 71a by rotating the first pivot axis 71s about a virtual pivot axis line A4 extending along the upward and downward direction. The first moving nozzle 71n is attached to a portion of the first arm 71a which is distant from the pivot axis line A4 in the horizontal direction.

Pivoting the first arm 71a causes the first moving nozzle 71n to move along an arc-shaped trajectory in the horizontal direction, as indicated by a double dot-dashed arrow in FIG. 6. The first arm driving mechanism 71m may, for example, move the first arm 71a up and down by elevating the first pivot axis 71s in the upward and downward direction.

The first moving nozzle 71n has a function of supplying a primary treatment liquid (also referred to as the first treatment liquid) to the upper surface Wa of the substrate W held by the holder 711. A first treatment liquid supply pipe P1 functioning as a pipe that supplies the first treatment liquid is coupled to the first moving nozzle 71n.

A first treatment liquid on-off valve V1 functioning as a valve that opens and closes a flow passage of the first treatment liquid supply pipe P1 is interposed in the first treatment liquid supply pipe P1. A treatment liquid distributor 701 or a treatment liquid distributor 702 to be described later supplies the first treatment liquid to the first treatment liquid supply pipe P1. Here, an acidic solution such as sulfuric acid (HSO) is used as the first treatment liquid. The first moving nozzle 71n may be a straight nozzle that ejects the first treatment liquid, or a two-fluid nozzle that mixes the first treatment liquid with inert gas and ejects the mixture.

A second moving unit 72M moves the second moving nozzle 72n in the horizontal direction. With the movement in the horizontal direction, the second moving nozzle 72n can be moved between a position facing the rotation center of the upper surface Wa of the substrate W held by the holder 711 (hereinafter referred to as a "second ejection position") and a position not facing the upper surface Wa of the substrate W held by the holder 711 (hereinafter referred to as a "second home position").

The second ejection position may be, for example, a position from which the second moving nozzle 72n ejects a second treatment liquid so that the second treatment liquid sits on the rotation center of the upper surface of the substrate W. The second home position is a position outside the holder 711 in a plan view. Specifically, the second home position may be a position outside the cup 717 in a plan view.

The movement of the second moving unit 72M in the upward and downward direction may bring the second moving nozzle 72n closer to the upper surface Wa of the substrate W held by the holder 711, or retract the second moving nozzle 72n upward from the upper surface Wa of the substrate W held by the holder 711.

The second moving unit 72M includes, for example, a second pivot axis 72s extending in the upward and downward direction, a second arm 72a coupled to the second pivot axis 72s and extending horizontally, and a second arm driving mechanism 72m driving the second arm 72a.

The second arm driving mechanism 72m pivots the second arm 72a by rotating the second pivot axis 72s about a virtual pivot axis line A5 extending along the upward and downward direction. The second moving nozzle 72n is attached to a portion of the second arm 72a which is distant from the pivot axis line A5 in the horizontal direction.

Pivoting the second arm 72a causes the second moving nozzle 72n to move along an arc-shaped trajectory in the horizontal direction, as indicated by a double dot-dashed arrow in FIG. 6. The second arm driving mechanism 72m may, for example, move the second arm 72a up and down by elevating the second pivot axis 72s in the upward and downward direction.

The second moving nozzle 72n has a function of supplying a secondary treatment liquid (also referred to as the second treatment liquid) to the upper surface Wa of the substrate W held by the holder 711. A second treatment liquid supply pipe P2 functioning as a pipe that supplies the second treatment liquid is coupled to the second moving nozzle 72n.

A second treatment liquid on-off valve V2 functioning as a valve that opens and closes a flow passage of the second treatment liquid supply pipe P2 is interposed in the second treatment liquid supply pipe P2. The treatment liquid distributor 701 or the treatment liquid distributor 702 to be described later supplies the second treatment liquid to the second treatment liquid supply pipe P2. Here, an alkaline solution such as ammonia hydrogen peroxide mixture (SC1) is used as the second treatment liquid. The second moving nozzle 72n may be a straight nozzle that ejects the second treatment liquid, or a two-fluid nozzle that mixes the second treatment liquid with inert gas and ejects the mixture.

A third moving unit 73M moves the third moving nozzle 73n in the horizontal direction. With the movement in the horizontal direction, the third moving nozzle 73n can be moved between a position facing the rotation center of the upper surface Wa of the substrate W held by the holder 711 (hereinafter referred to as a "third ejection position") and a position not facing the upper surface Wa of the substrate W held by the holder 711 (hereinafter referred to as a "third home position").

The third ejection position may be, for example, a position from which the third moving nozzle 73n ejects a third treatment liquid so that the third treatment liquid sits on the rotation center of the upper surface of the substrate W. The third home position is a position outside the holder 711 in a plan view. Specifically, the third home position may be a position outside the cup 717 in a plan view.

The movement of the third moving unit 73M in the upward and downward direction may bring the third moving nozzle 73n closer to the upper surface Wa of the substrate W held by the holder 711, or retract the third moving nozzle 73n upward from the upper surface Wa of the substrate W held by the holder 711.

The third moving unit 73M includes, for example, a third pivot axis 73s extending in the upward and downward direction, a third arm 73a coupled to the third pivot axis 73s and extending horizontally, and a third arm driving mechanism 73m driving the third arm 73a.

The third arm driving mechanism 73m pivots the third arm 73a by rotating the third pivot axis 73s about a virtual pivot axis line A6 extending along the upward and downward direction. The third moving nozzle 73n is attached to a portion of the third arm 73a which is distant from the pivot axis line A6 in the horizontal direction.

Pivoting the third arm 73a causes the third moving nozzle 73n to move along an arc-shaped trajectory in the horizontal direction, as indicated by a double dot-dashed arrow in FIG. 6. The third arm driving mechanism 73m may, for example, move the third arm 73a up and down by elevating the third pivot axis 73s in the upward and downward direction.

The third moving nozzle 73n has a function of supplying a tertiary treatment liquid (also referred to as the third treatment liquid) to the upper surface Wa of the substrate W held by the holder 711. A third treatment liquid supply pipe P3 functioning as a pipe that supplies the third treatment liquid is coupled to the third moving nozzle 73n.

A third treatment liquid on-off valve V3 functioning as a valve that opens and closes a flow passage of the third treatment liquid supply pipe P3 is interposed in the third treatment liquid supply pipe P3. The treatment liquid distributor 701 or the treatment liquid distributor 702 to be described later supplies the third treatment liquid to the third treatment liquid supply pipe P3. Here, a rinse liquid such as deionized water (DIW) is used as the third treatment liquid. The third moving nozzle 73n may be a straight nozzle that ejects the third treatment liquid, or a two-fluid nozzle that mixes the third treatment liquid with inert gas and ejects the mixture.

The treatment unit 76 includes, for example, a fan filter unit (FFU) as an air supplier 718. The FFU can clean the air even in a clean room in which the substrate treatment equipment 790 is disposed, and supply the cleaned air to the treatment chamber 761.

The FFU is attached to, for example, a ceiling wall of the treatment chamber 761. The FFU includes a fan and a filter (e.g., a HEPA filter) that draws in the air in the clean room and delivers the air to the treatment chamber 761, so that a downflow of the cleaned air can be formed in the treatment chamber 761. A punching plate with many blow outlets may be disposed immediately below the ceiling wall to distribute the cleaned air supplied from the FFU more uniformly to the treatment chamber 761.

For example, an exhaust outlet 762o connected in communication with the outside of the substrate treatment equipment 790 (an exhaust facility of a factory, etc.,) is formed in the vicinity of a floor wall of the treatment chamber 761. The vicinity is a part of a side wall of the treatment chamber 761. For example, the air passing through the vicinity of, for example, the cup 717 in the cleaned air supplied from the FFU and flowing down inside the treatment chamber 761 is ejected outside the substrate treatment equipment 790 through the exhaust outlet 762o. For example, a structure of introducing inert gas such as nitrogen gas may be added to an upper portion of the treatment chamber 761.

### [1-5. Structure of supply pipe spaces]

As illustrated in FIGS. 4 and 5, four supply pipe spaces 762 extend in the upward and downward direction. For example, the supply pipe space 762A extends in the upward and downward direction from the treatment unit 76A at the bottom tier (a first tier) to the treatment unit 76A at the top tier (a sixth tier). For example, the supply pipe space 762B extends in the upward and downward direction from the treatment unit 76B at the bottom tier (the first tier) to the treatment unit 76B at the top tier (the sixth tier). For example, the supply pipe space 762C extends in the upward and downward direction from the treatment unit 76C at the bottom tier (the first tier) to the treatment unit 76C at the top tier (the sixth tier). For example, the supply pipe space 762D extends in the upward and downward direction from the treatment unit 76D at the bottom tier (the first tier) to the treatment unit 76D at the top tier (the sixth tier). When there is no distinction between the supply pipe spaces 762A to 62D, these are simply referred to the supply pipe spaces 762.

The supply pipe spaces 762 are regions in which pipes for supplying fluids to the treatment chambers 761 are disposed. For example, the first treatment liquid supply pipe P1, the second treatment liquid supply pipe P2, the third treatment liquid supply pipe P3, the first treatment liquid on-off valve V1, the second treatment liquid on-off valve V2, and the third treatment liquid on-off valve V3 are disposed in each of the supply pipe spaces 762. The first treatment liquid supply pipe P1, the second treatment liquid supply pipe P2, and the third treatment liquid supply pipe P3 are drawn from the supply pipe space 762 into the treatment chamber 761, and are connected to the first moving nozzle 71n, the second moving nozzle 72n, and the third moving nozzle 73n, respectively.

### [1-6. Structure of exhaust pipe spaces]

As illustrated in FIGS. 4 and 5, four exhaust pipe spaces 763 extend in the upward and downward direction. For example, the exhaust pipe space 763A extends in the upward and downward direction from the treatment unit 76A at the bottom tier (the first tier) to the treatment unit 76A at the top tier (the sixth tier). For example, the supply pipe space 763B extends in the upward and downward direction from the treatment unit 76B at the bottom tier (the first tier) to the treatment unit 76B at the top tier (the sixth tier). For example, the supply pipe space 763C extends in the upward and downward direction from the treatment unit 76C at the bottom tier (the first tier) to the treatment unit 76C at the top tier (the sixth tier). For example, the supply pipe space 763D extends in the upward and downward direction from the treatment unit 76D at the bottom tier (the first tier) to the treatment unit 76D at the top tier (the sixth tier). When there is no distinction between the exhaust pipe spaces 763A to 63D, these are simply referred to as the exhaust pipe spaces 763.

The exhaust pipe spaces 763 are regions in which pipes for discharging gas from the treatment chambers 761 are disposed. As illustrated in FIGS. 4 to 7, for example, an exhaust duct switching mechanism 770, a first vertical exhaust pipe 771, a second vertical exhaust pipe 772, and a third vertical exhaust pipe 773 are disposed in each of the exhaust pipe spaces 763.

For example, the exhaust duct switching mechanism 770 is disposed in the exhaust pipe space 763A for each of the treatment chambers 761 from the treatment unit 76A at the bottom tier (the first tier) to the treatment unit 76A at the top tier (the sixth tier). For example, the exhaust duct switching mechanism 770 is disposed in the exhaust pipe space 763B for each of the treatment chambers 761 from the treatment unit 76B at the bottom tier (the first tier) to the treatment unit 76B at the top tier (the sixth tier). For example, the exhaust duct switching mechanism 770 is disposed in the exhaust pipe space 763C for each of the treatment chambers 761 from the treatment unit 76C at the bottom tier (the first tier) to the treatment unit 76C at the top tier (the sixth tier). For example, the exhaust duct switching mechanism 770 is disposed in the exhaust pipe space 763D for each of the treatment chambers 761 from the treatment unit 76D at the bottom tier (the first tier) to the treatment unit 76D at the top tier (the sixth tier).

The number of sets of the first vertical exhaust pipe 771, the second vertical exhaust pipe 772, and the third vertical exhaust pipe 773 is, for example, four. The first vertical exhaust pipe 771, the second vertical exhaust pipe 772, and the third vertical exhaust pipe 773 are, for example, pipes for discharging the gas discharged from the treatment chamber 761 outside the substrate treatment equipment 790 through the exhaust duct switching mechanism 770.

For example, the first vertical exhaust pipe 771, the second vertical exhaust pipe 772, and the third vertical exhaust pipe 773 in each of the exhaust pipe spaces 763 extend from the side of the treatment chamber 761 at the bottom tier (the first tier) to the side of the treatment chamber 761 at the top tier (the sixth tier). In each of the exhaust pipe spaces 763, for example, the first vertical exhaust pipe 771, the second vertical exhaust pipe 772, and the third vertical exhaust pipe 773 are aligned in the width direction (±Y direction). In each of the exhaust pipe spaces 763, the first vertical exhaust pipe 771, the second vertical exhaust pipe 772, and the third vertical exhaust pipe 773 have a function of discharging the gas flowing from each of the treatment chambers 761 of the treatment units 76 of the six tiers stacked in the upward and downward direction, through the exhaust duct switching mechanism 770.

When the first vertical exhaust pipes 771 are distinguished between the treatment units 76A to 76D, the first vertical exhaust pipes 771 will be referred to as first vertical exhaust pipes 771A to 771D. When the second vertical exhaust pipes 772 are distinguished between the treatment units 76A to 76D, the second vertical exhaust pipes 772 will be referred to as second vertical exhaust pipes 772A to 772D. When the third vertical exhaust pipes 773 are distinguished between the treatment units 76A to 76D, the third vertical exhaust pipes 773 will be referred to as third vertical exhaust pipes 773A to 773D.

The first set (first group) of the first vertical exhaust pipe 771A, the second vertical exhaust pipe 772A, and the third vertical exhaust pipe 773A is configured to discharge gas from each of the treatment units 76A of the six tiers. The second set (second group) of the first vertical exhaust pipe 771B, the second vertical exhaust pipe 772B, and the third vertical exhaust pipe 773B is configured to discharge gas from each of the treatment units 76B of the six tiers. The third set (third group) of the first vertical exhaust pipe 771C, the second vertical exhaust pipe 772C, and the third vertical exhaust pipe 773C is configured to discharge gas from each of the treatment units 76C of the six tiers. The fourth set (fourth group) of the first vertical exhaust pipe 771D, the second vertical exhaust pipe 772D, and the third vertical exhaust pipe 773D is configured to discharge gas from each of the treatment units 76D of the six tiers.

The exhaust duct switching mechanism 770 is a mechanism for switching an exhaust duct of gas from the treatment chambers 761 to the outside of the substrate treatment equipment 790, to an exhaust duct through any one vertical exhaust pipe of the first vertical exhaust pipe 771, the second vertical exhaust pipe 772, and the third vertical exhaust pipe 773.

The exhaust duct switching mechanism 770 is disposed at lateral sides of the treatment chambers 761. The exhaust duct switching mechanism 770communicates, for example, with each of the treatment chambers 761 through the exhaust outlet 762o for discharging the gas in the treatment chamber 761. Furthermore, the exhaust duct switching mechanism 770 communicates, for example, with the first vertical exhaust pipe 771, the second vertical exhaust pipe 772, and the third vertical exhaust pipe 773 each extending in the upward and downward direction.

As illustrated in FIG. 6, the exhaust duct switching mechanism 770 includes, for example, a first opening and closing part 71d and a second opening and closing part 72d. Each of the first opening and closing part 71d and the second opening and closing part 72d has, for example, a door-like structure, and operates as a side-swinging door.

Each of the first opening and closing part 71d and the second opening and closing part 72d rotates about a pivot axis by driving, for example, a motor. For example, opening or closing the first opening and closing part 71d and the second opening and closing part 72d sets the exhaust duct switching mechanism 770 to any one of states, that is, a state of causing gas to flow from the treatment space 761s into the first vertical exhaust pipe 771 (also referred to as a first state), a state of causing gas to flow from the treatment space 761s into the second vertical exhaust pipe 772 (also referred to as a second state), and a state of causing gas to flow from the treatment space 761s into the third vertical exhaust pipe 773 (also referred to as a third state).

For example, during a period in which the first moving nozzle 71n ejects a first chemical solution, the exhaust duct switching mechanism 770 is set to the first state. For example, during a period in which the second moving nozzle 72n ejects a second chemical solution, the exhaust duct switching mechanism 770 is set to the second state. For example, during a period in which the third moving nozzle 73n ejects a third chemical solution, the exhaust duct switching mechanism 770 is set to the third state.

### [1-7. Structure of horizontal exhaust system]

As illustrated in FIGS. 3 to 5, the horizontal exhaust system 780 includes a first horizontal exhaust pipe 781A, a second horizontal exhaust pipe 782A, a third horizontal exhaust pipe 783A, a first horizontal exhaust pipe 781B, a second horizontal exhaust pipe 782B, a third horizontal exhaust pipe 783B.

As illustrated in FIGS. 3 and 4, for example, the first horizontal exhaust pipe 781A, the second horizontal exhaust pipe 782A, and the third horizontal exhaust pipe 783A are disposed above the two treatment units 76A and 76B at the top tier (the sixth tier) to extend in the front and rear direction (±X direction). The first horizontal exhaust pipe 781A, the second horizontal exhaust pipe 782A, and the third horizontal exhaust pipe 783A are, for example, aligned in the width direction (±Y direction).

For example, the first vertical exhaust pipe 771A for the treatment unit 76A and the first vertical exhaust pipe 771B for the treatment unit 76B are connected in communication with the first horizontal exhaust pipe 781A. The first horizontal exhaust pipe 781A discharges gas from the first vertical exhaust pipes 771A and 771B.

For example, the second vertical exhaust pipe 772A for the treatment unit 76A and the second vertical exhaust pipe 772B for the treatment unit 76B are connected in communication with the second horizontal exhaust pipe 782A. The second horizontal exhaust pipe 782A discharges gas from the second vertical exhaust pipes 772A and 772B.

For example, the third vertical exhaust pipe 773A for the treatment unit 76A and the third vertical exhaust pipe 773B for the treatment unit 76B are connected in communication with the third horizontal exhaust pipe 783A. The third horizontal exhaust pipe 783A discharges gas from the third vertical exhaust pipes 773A and 773B.

As illustrated in FIGS. 3 and 5, for example, the first horizontal exhaust pipe 781B, the second horizontal exhaust pipe 782B, and the third horizontal exhaust pipe 783B are disposed above the two treatment units 76C and 76D at the top tier (the sixth tier) to extend in the front and rear direction (±X direction). The first horizontal exhaust pipe 781B, the second horizontal exhaust pipe 782B, and the third horizontal exhaust pipe 783B are, for example, aligned in the width direction (±Y direction).

For example, each of the first vertical exhaust pipe 771C for the treatment unit 76C and the first vertical exhaust pipe 771D for the treatment unit 76D are connected in communication with the first horizontal exhaust pipe 781B. The first horizontal exhaust pipe 781B discharges gas from the first vertical exhaust pipes 771C and 771D.

For example, the second vertical exhaust pipe 772C for the treatment unit 76C and the second vertical exhaust pipe 772D for the treatment unit 76D are connected in communication with the second horizontal exhaust pipe 782B. The second horizontal exhaust pipe 782B discharges gas from the second vertical exhaust pipes 772C and 772D.

For example, the third vertical exhaust pipe 773C for the treatment unit 76C and the third vertical exhaust pipe 773D for the treatment unit 76D are connected in communication with the third horizontal exhaust pipe 783B. The third horizontal exhaust pipe 783B discharges gas from the third vertical exhaust pipes 773C and 773D.

The first horizontal exhaust pipe 781A, the second horizontal exhaust pipe 782A, and the third horizontal exhaust pipe 783A are longer than the first horizontal exhaust pipe 781B, the second horizontal exhaust pipe 782B, and the third horizontal exhaust pipe 783B.

The gas flows rearward (in the +X direction) inside each of the first horizontal exhaust pipe 781A, the second horizontal exhaust pipe 782A, the third horizontal exhaust pipe 783A, the first horizontal exhaust pipe 781B, the second horizontal exhaust pipe 782B, and the third horizontal exhaust pipe 783B.

The substrate treatment equipment 790 includes, for example, an exhaust part 768 including the four exhaust pipe spaces 763 and the horizontal exhaust system 780. This exhaust part 768 can discharge gas from the treatment chambers 761 to the outside of the substrate treatment equipment 790 (an exhaust facility of a factory, etc).

A treatment liquid storage 705 is disposed rearward (in the +X direction) of the substrate treatment equipment 790. The treatment liquid storage 705 stores the treatment liquid distributors 701 and 702, and treatment liquid supply sources 703 and 704. For example, the treatment liquid supply source 703 stores a chemical solution, and the treatment liquid supply source 704 stores a rinse liquid.

The treatment liquid distributors 701 and 702 obtain treatment liquids, specifically, the chemical solution from the treatment liquid supply source 703, and the rinse liquid from the treatment liquid supply source 704. The treatment liquid distributor 701 distributes the treatment liquid to the treatment units 76C and 76D. The treatment liquid distributor 702 distributes the treatment liquid to the treatment units 76A and 76B.

The pipes for supplying the treatment liquid from the treatment liquid distributor 701 to the treatment units 76C and the treatment units 76D are disposed in the supply pipe space 762C and the supply pipe space 762D, respectively. The pipes for supplying the treatment liquid from the treatment liquid distributor 702 to the treatment units 76A and the treatment units 76B are disposed in the supply pipe space 762A and the supply pipe space 762B, respectively.

### [1-8. Control system of substrate treatment equipment]

As illustrated in FIG. 1, for example, the substrate treatment equipment 790 includes a controller 79. The controller 79 is, for example, a part for controlling operations of each of the constituents of the substrate treatment equipment 790.

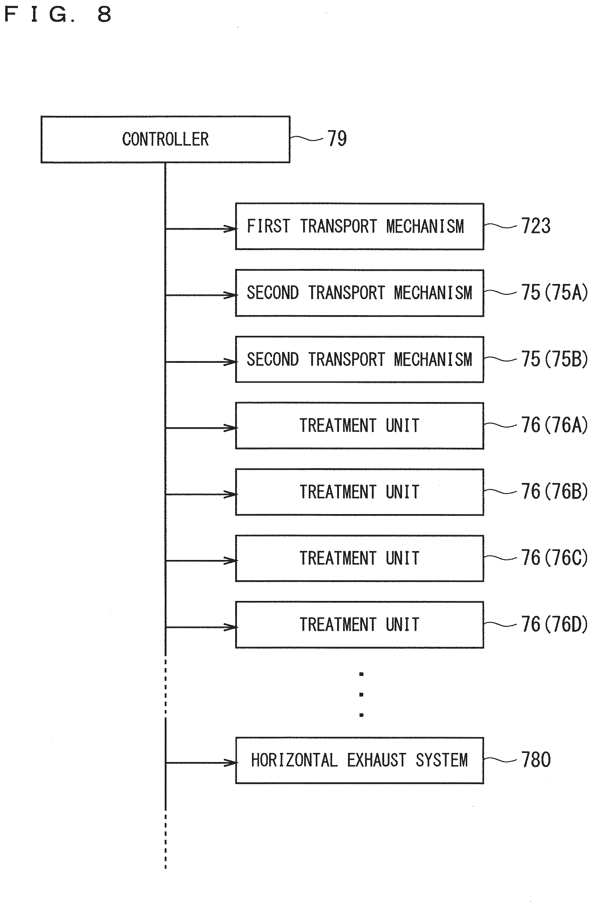

FIG. 8 is a block diagram illustrates a functional configuration for controlling the operations of each of the constituents of the substrate treatment equipment 790. The controller 79 is communicatively connected to the first transport mechanism 723, the second transport mechanisms 75, the plurality of treatment units 76, and the horizontal exhaust system 780.

Specifically, the controller 79 is communicatively connected to, for example, elements to be controlled in the plurality of treatment units 76 and the horizontal exhaust system 780. This enables the controller 79 to, for example, control operations of the first transport mechanism 723, the second transport mechanisms 75, the plurality of treatment units 76, and the horizontal exhaust system 780.

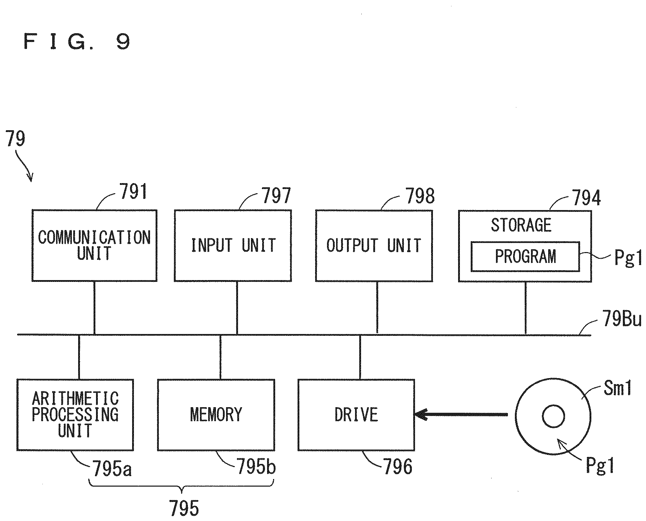

FIG. 9 is a block diagram illustrating one example configuration of the controller 79. The controller 79 is implemented by, for example, a common computer. The controller 79 includes, for example, a communication unit 791, an input unit 797, an output unit 798, a storage 794, a processing unit 795, and a drive 796 that are connected through a bus line 79Bu.

The communication unit 791, for example, transmits and receives a signal to and from each of the first transport mechanism 723, the second transport mechanisms 75, the plurality of treatment units 76, and the horizontal exhaust system 780 through a communication line. The communication unit 791 may, for example, receive a signal from a management server for managing the substrate treatment equipment 790.

The input unit 797 receives a signal corresponding to, for example, an operation of an operator. Examples of the input unit 797 include operating parts such as a mouse and a keyboard that can receive a signal corresponding to an operation, a microphone that can receive a signal corresponding to voice, and various sensors that can receive signals corresponding to movement.

The output unit 798 outputs, for example, various pieces of information in a format that can be recognized by the operator. Examples of the output unit 798 include a display that visibly outputs various pieces of information, and a speaker that audibly outputs various pieces of information. The display may be, for example, in the form of a touch panel integrated with at least a part of the input unit 797.

The storage 794 stores, for example, a program Pg1 and various pieces of information. The storage 794 includes, for example, a nonvolatile storage medium such as a hard disk or a flash memory. The storage 794 may have, for example, any one of a structure with a single storage medium, a structure of integrally having at least two storage media, and a structure with at least two parts separated from at least two storage media. The storage stores, for example, information on operating conditions of the first transport mechanism 723, the second transport mechanisms 75, the plurality of treatment units 76, and the horizontal exhaust system 780. Examples of the information on operating conditions of the treatment units 76 include a treatment recipe (a process recipe) for treating the substrates W.

The processing unit 795 includes, for example, an arithmetic processing unit 795a that functions as a processor, and a memory 795b as a work area for arithmetic processes. For example, an electronic circuit such as a central processing unit (CPU) is used as the arithmetic processing unit 795a. For example, a random access memory (RAM) is used as the memory 795b. The processing unit 795 implements functions of the controller 79, for example, by reading and executing the program Pg1 stored in the storage 794. In the controller 79, for example, the processing unit 795 performs the arithmetic processes according to the procedure written in the program Pg1 to implement various functional units that control operations of the elements of the substrate treatment equipment 790. In other words, the controller 79 included in the substrate treatment equipment 790 executes the program Pg1, so that functions and operations of the substrate treatment equipment 790 can be implemented. For example, a dedicated logic circuit may implement, hardware wise, a part or all the functional units implemented by the controller 79.

The drive 796 is, for example, a portion from which a transportable storage medium Sm1 can be detached. The drive 796 to which the storage medium Sm1 is attached causes this storage medium Sm1 and the processing unit 795 to exchange data. The drive 796 to which the storage medium Sm1 storing the program Pg1 is attached causes the storage medium Sm1 to read and store the program Pg1 in the storage 794.

Example operations of the whole substrate treatment equipment 790 will be described. For example, the substrate treatment equipment 790 controls the elements included in the substrate treatment equipment 790 according to a recipe in which, for example, a procedure of transporting the substrates W and treatment conditions have been written, so that a series of operations to be described below is performed.

Once the carrier C containing untreated substrates W are placed on the carrier placement part 721, the first transport mechanism 723 takes the untreated substrates W from this carrier C. The first transport mechanism 723 transports the untreated substrates W to the substrate placement parts 77. The second transport mechanisms 75 transport the untreated substrates W from the substrate placement parts 77 to the treatment units 76 designated according to, for example, the recipe. The substrates W may be transferred, for example, directly between the hand 7231 and the hand 751 without through the substrate placement parts 77, between the first transport mechanism 723 and the second transport mechanisms 75.

The treatment units 76 to which the substrates W have been transported execute a series of defined substrate treatments on the substrates W. In this series of substrate treatments, for example, a chemical solution and then a rinse liquid are supplied in this order onto the upper surface Wa of the substrate W held by the holder 711.

The treatment using the rinse liquid may be followed by supplying an organic solvent. After the treatment using the organic solvent, for example, the organic solvent is removed from the upper surface Wa of the substrate W to apply a treatment of drying the upper surface Wa of the substrate W (hereinafter also referred to as a "drying treatment"). In the drying treatment, for example, the electric motor 711m as a driver rotates the substrate W held by the holder 711 about the rotation axis line A3.

When this series of substrate treatments on the substrates W ends in the treatment units 76, the second transport mechanisms 75 take the treated substrates W from the treatment units 76. The second transport mechanisms 75 transport the treated substrates W to the substrate placement parts 77. The first transport mechanism 723 transports the substrates W from the substrate placement parts 77 to the carrier C on the carrier placement part 721.

In the substrate treatment equipment 790, the first transport mechanism 723 and the second transport mechanisms 75 repeatedly perform the aforementioned transport operations according to the recipe, and each of the treatment units 76 executes the series of substrate treatments on the substrate W according to the treatment recipe. Accordingly, the series of substrate treatments on the substrates W is performed one after another.

### [2. Description of circulation apparatus]

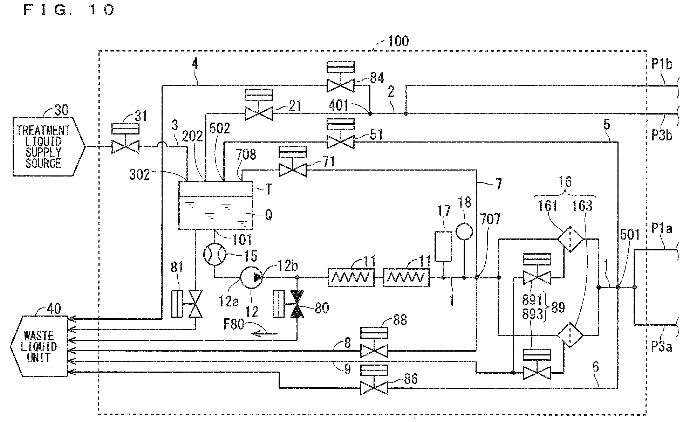

FIGS. 10, and 13 to 19 are plumbing diagrams each exemplifying a structure of a circulation apparatus 100. These diagrams also illustrate a treatment liquid supply source 30 and a waste liquid unit 40 which are disposed outside the circulation apparatus 100 and will be described later.

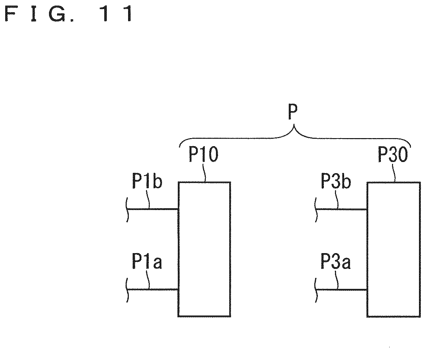

FIG. 11 is a diagram exemplifying a structure of an external path P outside the circulation apparatus 100. The circulation apparatus 100 supplies and collects a liquid Q to and from the external path P. Specifically, the external path P consists of towers P10 and P30. The liquid Q is supplied to the tower P10 and the tower P30 through a pipe P1a and a pipe P3a, respectively. The liquid Q is collected from the tower P10 and the tower P30 through a pipe P1b and a pipe P3b, respectively.

The circulation apparatus 100 can be employed as any of the treatment liquid distributors 701 and 702.

When the circulation apparatus 100 is employed as the treatment liquid distributor 701, for example, the pipes P1aand P1b are pipes through which a treatment liquid flows in the six treatment units 76C, and the pipes P3a and P3b are pipes through which a treatment liquid flows in the six treatment units 76D.

For example, the treatment liquid is supplied and collected to and from the tower P10 and the six treatment units 76C through the pipes P1aand P1b. For example, the treatment liquid is supplied and collected to and from the tower P30 and the six treatment units 76D through the pipes P3a and P3b. The pipes P1a and P1b are disposed in the supply pipe space 762C, and the pipes P3a and P3b are disposed in the supply pipe space 762D.

When the circulation apparatus 100 is employed as the treatment liquid distributor 702, for example, the tower P10 is a pipe through which a treatment liquid flows in the six treatment units 76A, and the tower P30 is a pipe through which a treatment liquid flows in the six treatment units 76B.

For example, the treatment liquid is supplied and collected to and from the tower P10 and the six treatment units 76A through the pipes P1a and P1b. For example, the treatment liquid is supplied and collected to and from the tower P30 and the six treatment units 76B through the pipes P3a and P3b. The pipes P1a and P1b are disposed in the supply pipe space 762A, and the pipes P3a and P3b are disposed in the supply pipe space 762B.

The circulation apparatus 100 includes a storage tank T. An object to be stored in the storage tank T is the liquid Q. The liquid Q is, for example, sulfuric acid or a dilution of sulfuric acid (dilute sulfuric acid).

The circulation apparatus 100 includes a valve 81. The valve 81 is connected to the storage tank T. The valve 81 controls discharge of the liquid Q from the storage tank T to the outside of the circulation apparatus 100, specifically, for example, to the waste liquid unit 40.

The circulation apparatus 100 includes a pipe 1. The pipe 1 includes an inflow end 101, and is used for supplying the liquid Q through the pipes P1a and P3a. The pipe 1 may conceivably include the pipes P1a and P3a. The liquid Q flows from the storage tank T into the inflow end 101.

The circulation apparatus 100 includes a pipe 2. The pipe 2 includes an outflow end 202, and is used for collecting the liquid Q through the pipes P1b and P3b. The pipe 2 may conceivably include the pipes P1b and P3b. The liquid Q flows from the outflow end 202 to the storage tank T.

The circulation apparatus 100 includes a valve 21. The valve 21 is disposed in the pipe 2, and controls an outflow of the liquid Q from the outflow end 202 to the storage tank T. For example, an on-off valve is employed as the valve 21.

A circulation in which the liquid Q flows from the storage tank T and flows into the storage tank T, through the pipes 1 and 2 and the valve 21 is generally referred to as the "external circulation". The pipes 1 and 2 and the valve 21 contributing to the external circulation may be referred to as an external circulation path.

The circulation apparatus 100 includes a pump 12. The pump 12 is disposed in the pipe 1. The pump 12 includes an inlet 12a and an outlet 12b. The inlet 12a is connected to the inflow end 101. An object to be expelled by the pump 12 from the inlet 12a to the outlet 12b is the liquid Q. For example, a magnetic levitation centrifugal pump is employed as the pump 12. For example, a bearingless pump of Levitronix Technologies Inc. is employed as the magnetic levitation centrifugal pump.

The circulation apparatus 100 includes heaters 11. The heaters 11 are disposed in the pipe 1 and connected to the outlet 12b. An object to be heated by the heaters 11 is the liquid Q. For example, a pair of the heaters 11 is disposed in series with each other in the pipe 1.

The circulation apparatus 100 includes a pipe 3. The pipe 3 is a path of the liquid Q to be stored in the storage tank T from the outside of the circulation apparatus 100, specifically, for example, from the treatment liquid supply source 30. The pipe 3 includes an outflow end 302. The liquid Q flows from the outflow end 302 to the storage tank T.

When the circulation apparatus 100 is employed as the treatment liquid distributor 701, the treatment liquid supply source 703 functions as the treatment liquid supply source 30. When the circulation apparatus 100 is employed as the treatment liquid distributor 702, the treatment liquid supply source 704 functions as the treatment liquid supply source 30.

The circulation apparatus 100 includes a valve 31. The valve 31 is disposed in the pipe 3, and controls an outflow of the liquid Q from the outflow end 302 to the storage tank T. For example, an on-off valve is employed as the valve 31.

The circulation apparatus 100 includes a pipe 4. The pipe 4 is connected to the pipe 2 on the opposite side of the outflow end 202 with respect to the valve 21. For example, the pipe 4 includes an end 401, and the end 401 is connected to the pipe 2. The end 401 is located between the valve 21 and the pipes P1b and P3b. The pipe 4 is a path of the liquid Q to be discharged from the pipe 2 to the outside of the circulation apparatus 100, specifically, for example, to the waste liquid unit 40.

The circulation apparatus 100 includes a valve 84. The valve 84 is disposed in the pipe 4, and controls discharge of the liquid Q. For example, an on-off valve is employed as the valve 84.

The circulation apparatus 100 includes a pipe 5. The pipe 5 is connected to the pipe 1 on the opposite side of the pump 12 with respect to the heaters 11. The pipe 5 includes an outflow end 502. The liquid Q flows from the outflow end 502 to the storage tank T. For example, the pipe 5 includes an end 501, and the end 501 is connected to the pipe 1. The end 501 is located between the heaters 11 and the pipes P1a and P3a.

The circulation apparatus 100 includes a valve 51. The valve 51 is disposed in the pipe 5, and controls an outflow of the liquid Q from the outflow end 502 to the storage tank T. For example, an on-off valve is employed as the valve 51.

A circulation in which the liquid Q flows from the storage tank T and flows into the storage tank T, through the pipes 1 and 5 and the valve 51 is generally referred to as the "internal circulation". The pipes 1 and 5 and the valve 51 contributing to the internal circulation may be referred to as an internal circulation path.

The circulation apparatus 100 includes a pipe 6. The pipe 6 is connected to the pipe 5 on the opposite side of the outflow end 502 with respect to the valve 51. For example, the pipe 6 is connected to the pipe 5 at the end 501. The pipe 6 is a path of the liquid Q to be discharged from the pipe 5 to the outside of the circulation apparatus 100, specifically, for example, to the waste liquid unit 40.

The circulation apparatus 100 includes a valve 86. The valve 86 is disposed in the pipe 6, and controls discharge of the liquid Q. For example, an on-off valve is employed as the valve 86.

The circulation apparatus 100 includes filters 16. The filters 16 are disposed in the pipe 1 between the heaters and the pipes 5 and 6. The filters 16 have a function of removing impurities from the liquid Q.

For example, a pair of filters 161 and 163 that are connected in parallel in the pipe 1 is employed as the filters 16. Such a parallel connection contributes to reduction of a pressure loss in the filters 16 and further in the pipe 1.

The circulation apparatus 100 includes a pipe 7. The pipe 7 includes an outflow end 708. The pipe 7 is connected to the pipe 1 between the heaters 11 and the filters 16. For example, the pipe 7 is connected to the pipe 1 at an end 707. The liquid Q flows from the outflow end 708 to the storage tank T.

The circulation apparatus 100 includes a valve 71. The valve 71 is disposed in the pipe 7, and controls an outflow of the liquid Q from the outflow end 708 to the storage tank T. For example, an on-off valve is employed as the valve 71.

A circulation in which the liquid Q flows from the storage tank T and flows into the storage tank T, through the pipes 1 and 7 and the valve 71 is generally referred to as a "preliminary circulation". The pipes 1 and 7 and the valve 71 contributing to the preliminary circulation may be referred to as a preliminary circulation path.

The circulation apparatus 100 includes a pipe 8. The pipe 8 is connected to the pipe 7 on the opposite side of the outflow end 708 with respect to the valve 71. For example, the pipe 8 is connected to the pipe 7 at the end 707. The pipe 8 is a path of the liquid Q to be discharged from the pipe 7 to the outside of the circulation apparatus 100, specifically, for example, to the waste liquid unit 40.

The circulation apparatus 100 includes a valve 88. The valve 88 is disposed in the pipe 8, and controls discharge of the liquid Q. For example, an on-off valve is employed as the valve 88.

The circulation apparatus 100 includes a pipe 9. The pipe 9 is connected to the filters 16. The pipe 9 is a path of the liquid Q to be discharged from the filters 16 to the outside of the circulation apparatus 100, specifically, for example, to the waste liquid unit 40.

The circulation apparatus 100 includes valves 89. The valves 89 are disposed in the pipe 9, and control discharge of the liquid Q. For example, a valve 891 connected to the filter 161 and a valve 893 connected to the filter 163 are employed as the valves 89. For example, on-off valves are employed as the valves 891 and 893.

The circulation apparatus 100 includes a valve 80. The valve 80 is connected to the outlet 12b. The valve 80 controls discharge of the liquid Q to the outside of the circulation apparatus 100, specifically, for example, to the waste liquid unit 40.

The circulation apparatus 100 includes a flowmeter 15. The flowmeter 15 is disposed between the inflow end 101 and the inlet 12a. The flowmeter 15 measures a flow rate of the liquid Q in the pipe 1.

The circulation apparatus 100 includes a thermometer 17 and a pressure gauge 18. The thermometer 17 and the pressure gauge 18 are disposed, for example, between the heaters 11 and the filters 16. The thermometer 17 measures a temperature of the liquid Q in the pipe 1. The pressure gauge 18 measures a pressure of the liquid Q in the pipe 1.

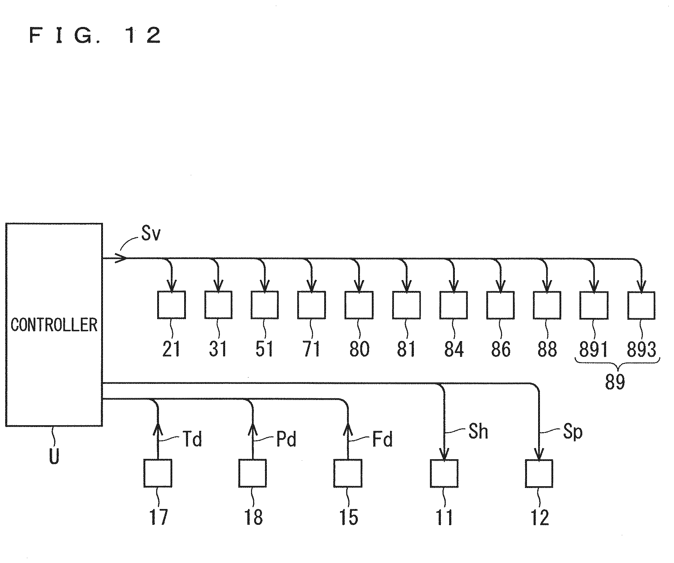

FIG. 12 is a block diagram illustrating an outline of functions of a controller U. The controller U controls operations of the valves 21, 31, 51, 71, 80, 81, 84, 86, 88, and 89. For example, the controller U provides control signals Sv to the valves 21, 31, 51, 71, 80, 81, 84, 86, 88, and 89 to control opening and closing of these.

The controller U controls operations of the heaters 11 and the pump 12. For example, the controller U provides a control signal Sh to the heaters 11 to control heating of the liquid Q by the heaters 11. For example, the controller U provides a control signal Sp to the pump 12 to control a flow rate of the liquid Q from the pump 12.

The controller U receives, from the flowmeter 15, data Fd indicating the flow rate of the liquid Q flowing through the pipe 1. The controller U receives, from the thermometer 17, data Td indicating the temperature of the liquid Q (hereinafter simply referred to as a "liquid temperature") in the pipe 1. The controller U receives, from the pressure gauge 18, data Pd indicating the pressure of the liquid Q in the pipe 1.

A known technology is used for the controller U to control a rotation speed of the pump 12 using the control signal Sp based on the data Fd and the data Pd and to control heating of the liquid Q by the heaters 11 using the control signal Sh based on the data Td. Thus, details on the technology for controlling the heaters 11 and the pump 12 are omitted.

The following will describe relations between three subjects, namely, operations of opening and closing the valves, liquid temperatures, and operations of the pump 12 (specifically, driving and deactivating (hereinafter simply referred to as "ON" and "OFF", respectively). In the following description, a pair of black triangles is used to represent a symbol of a valve that is open (hereinafter also referred to as "being opened"), and a pair of triangles that are not filled is used to represent a symbol of a valve that is close (hereinafter also referred to as "being closed").

### [2-1. Temperature control before exchanging liquid]

The liquid Q before exchange is discharged from the circulation apparatus 100 for exchanging the liquid Q. The liquid Q is easily discharged when the viscosity of the liquid Q is low. The viscosity of the liquid Q is lower when the temperature of the liquid Q is higher.

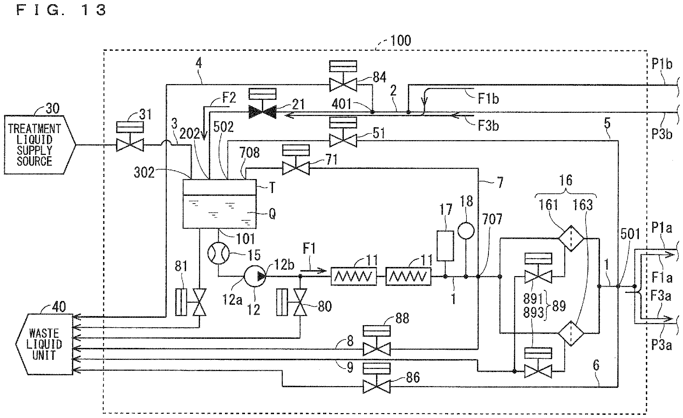

FIG. 13 illustrates a state in which a process J1 is executed. In the process J1, the liquid temperatures of the liquid Q in the circulation apparatus 100 and the liquid Q in the external path P are increased during a first period prior to the discharge.

In the process J1, the valves 81, 31, 84, 51, 86, 71, 80, 88, and 89 are closed, the valve 21 is opened, the heaters 11 are driven to increase the temperature of the liquid Q, and the pump 12 is turned ON. For example, the temperature of the liquid Q is increased to 140°C.

The liquid Q of which temperature has been increased is externally circulated. Specifically, as indicated by a liquid stream F1, the liquid Q flows in the pipe 1 from the inflow end 101 through the pump 12, the heaters 11, and the filters 16 in this order. The liquid stream F1 branches off to a liquid stream F1a flowing through a pipe P1a, and a liquid stream F1b flowing through a pipe P1b. The liquid stream F1a and the liquid stream F3a flow into the tower P10 and the tower P30, respectively.

The liquid Q flows from the tower P10 into the pipe 2 through the pipe P1b as a liquid stream F1b. The liquid Q flows from the tower P30 into the pipe 2 through the pipe P3b as a liquid stream F3b. The liquid streams F1b and F3b merge in the pipe 2 to flow as a liquid stream F2. The liquid stream F2 flows from the outflow end 202 to the storage tank T through the valve 21.

FIG. 10 illustrates an example state immediately before the process J1 is performed. The pump 12 is not driven, and the valve 80 is opened. The liquid Q flows from the valve 80 to the waste liquid unit 40 as a liquid stream F80. When a magnetic levitation centrifugal pump is employed as the pump 12, such a state is regarded as a preliminary state in which the pump 12 is made liquid-tight and which contributes to easily driving the pump 12 in the following steps. The valve 21 may be opened in this preliminary state.

### [2-2. Discharge of treatment liquid]

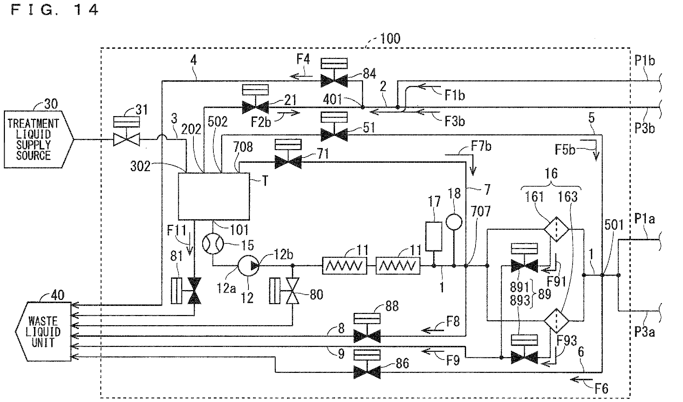

FIG. 14 illustrates a state in which a process J2 is executed. The process J2 is executed during a second period after the process J1. In the process J2, the liquid Q is discharged from the circulation apparatus 100. Since the process J2 is a process before the liquid Q is newly stored in the storage tank T, the valve 31 is closed.

In the process J2, the valve 81 is opened, and the liquid Q in the storage tank T is discharged outside, specifically, to the waste liquid unit 40. This discharge of the liquid Q is illustrated as a liquid stream F11.

In the process J2, the valves 21 and 84 are opened, and the liquid Q in the pipes P1b, P3b, and 2 is discharged outside, specifically, to the waste liquid unit 40. The liquid Q flows as a liquid stream F2b in a direction from the inflow end 202 toward the end 401. The liquid stream F1b from the pipe P1b toward the end 401, the liquid stream F3b from the pipe P3b toward the end 401, and the liquid stream F2b merge to flow as a liquid stream F4, so that the liquid Q is discharged to the waste liquid unit 40 through the valve 84.

In the process J2, the valves 51 and 86 are opened, and the liquid Q in the pipe 5 is discharged outside, specifically, to the waste liquid unit 40. The liquid Q flows as a liquid stream F5b in a direction from the inflow end 502 toward the end 501. The liquid stream F5b flows through the pipe 6 as a liquid stream F6, and the liquid Q is discharged to the waste liquid unit 40 through the valve 86.

In the process J2, the valves 71 and 88 are opened, and the liquid Q in the pipe 7 is discharged outside, specifically, to the waste liquid unit 40. The liquid Q flows as a liquid stream F7b in a direction from the inflow end 708 toward the end 707. The liquid stream F7b flows through the pipe 8 as a liquid stream F8, and the liquid Q is discharged to the waste liquid unit 40 through the valve 88.

In the process J2, the valves 89 are opened, and the liquid Q in the pipe 6 and the filters 16 is discharged outside, specifically, to the waste liquid unit 40. The liquid Q flows from the filter 161 as a liquid stream F91 through the valve 891. The liquid Q flows from the filter 163 as a liquid stream F93 through the valve 893. The liquid streams F91 and F93 merge in the pipe 9 to flow as a liquid stream F9, and the liquid Q is discharged to the waste liquid unit 40.

These may be discharged due to the self-weight of the liquid Q. The viscosity of the liquid Q is low because the liquid Q is heated to a predetermined high temperature (140°C in the aforementioned example) in the process J1. This makes it easier to estimate the discharge required time of the liquid Q, without depending on the liquid temperature of the liquid Q remaining before the process J1 is executed. The process J2 contributes to efficiently discharging the remaining treatment liquid and further improve the efficiency of liquid exchange.

In the process J2, the pump 12 is deactivated, and the valve 80 is closed. Such a state is suitable particularly when a magnetic levitation centrifugal pump is employed as the pump 12. This is because filling the inlet 12a to the outlet 12b with the liquid Q is preferable to cause the pump 12 to normally operate. In view of this, it can be regarded that the liquid Q that has not been discharged from the circulation apparatus 100 remains also in the process J2.

### [2-3. Storage of treatment liquid]

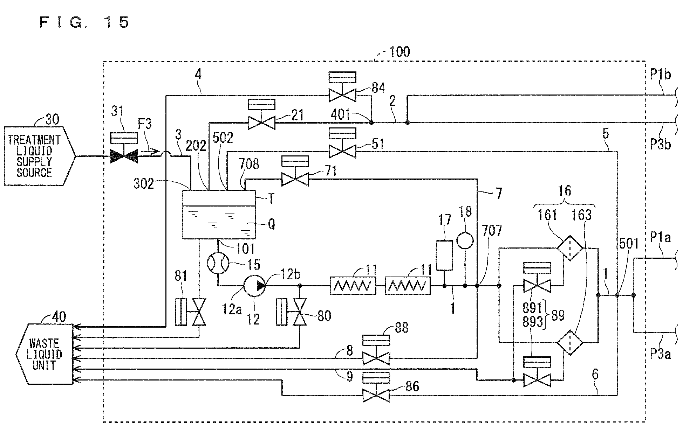

FIG. 15 illustrates a state in which a process J3 is executed. The process J3 is executed during a third period after the process J2. In the process J3, the liquid Q is stored in the storage tank T from the outside, specifically, from the treatment liquid supply source 30. In the process J3, the pump 12 is deactivated, and the valves 80 and 81 are closed, and the valve 31 is opened. Although it does not matter whether the valves 21, 51, 71, 84, 86, 88, and 89 are opened or closed, FIG. 15 exemplifies a case where these are closed.

Opening the valve 31 allows the liquid Q to flow from the treatment liquid supply source 30 to the outflow end 302 through the valve 31 as a liquid stream F3 so that the liquid Q is stored in the storage tank T. The liquid temperature of the liquid Q to be stored in the storage tank T in the process J3 is, for example, room temperatures.

### [2-4. External circulation of treatment liquid]

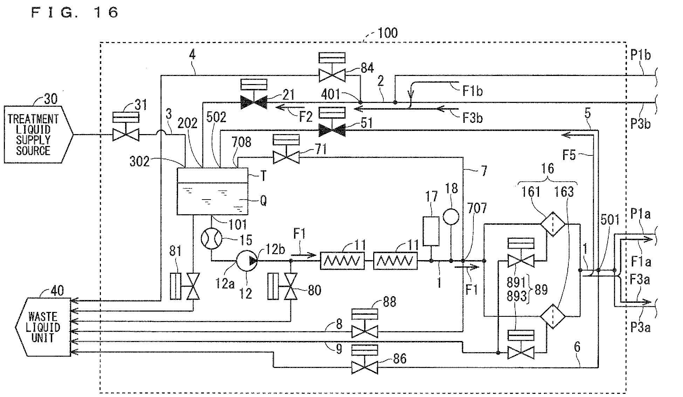

FIG. 16 illustrates a state in which a process J4 is executed. The process J4 is executed during a fourth period after the process J3. In the process J4, the liquid Q newly stored in the storage tank T in the process J3 is externally circulated and internally circulated. In the process J4, the pump 12 is turned ON.

In the process J4, the heaters 11 are driven to increase the temperature of the liquid Q. For example, the liquid temperature Qt is increased to 140°C.

In the process J4, the valves 31, 71, 80, 81, 84, and 88 are closed, and the valve 21 is opened. The liquid Q flows from the tower P10 into the pipe 2 through the pipe P1b as the liquid stream F1b. The liquid Q flows from the tower P30 into the pipe 2 through the pipe P3b as the liquid stream F3b. The liquid streams F1b and F3b merge in the pipe 2 to flow as the liquid stream F2. The liquid stream F2 flows from the outflow end 202 to the storage tank T through the valve 21.

The valve 51 is opened, the valve 86 is closed, and the liquid Q flows in the pipe 5 as a liquid stream F5 from the end 501 toward the outflow end 502 through the valve 51.

The valves 89 are closed, and the liquid stream F1 flowing through the pipe 1 branches off to the aforementioned liquid stream F5, the liquid stream F1a flowing toward the tower P10 through the pipe P1a, and the liquid stream F3a flowing toward the tower P30 through the pipe P3a. The liquid Q of which temperature has been increased is externally circulated and internally circulated.

Thus, increasing the temperature of the liquid Q in the circulation apparatus 100 before newly introducing the liquid Q to the circulation apparatus 100 and prior to discharging the existing liquid Q from the circulation apparatus 100 reduces the viscosity of the liquid. Then, the liquid Q is discharged. As such, increasing the liquid temperature before discharging the liquid contributes to reduction of a period required to discharge the liquid.

### [2-5. Internal circulation of treatment liquid]

Internally circulating the liquid Q and increasing the liquid temperature prior to the process J4 contribute to reduction of the viscosity of the liquid Q served to the external circulation in the process J4 and thus smoothly performing the external circulation.

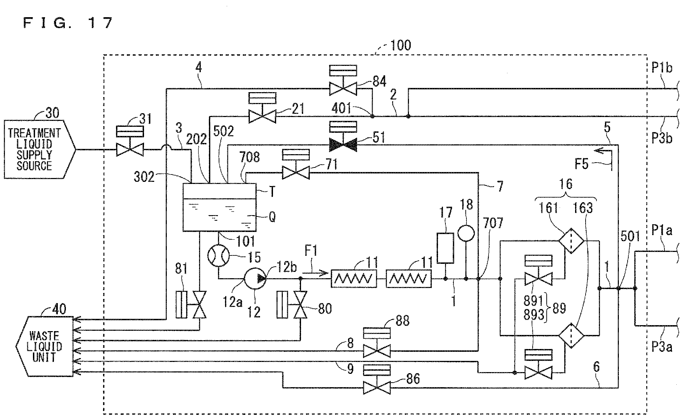

FIG. 17 illustrates a state in which a process J5 is executed. The process J5 is executed during a fifth period between the process J3 in which the treatment liquid is stored and the process J4 in which the external circulation is performed. In the process J5, the valve 51 is opened, and the valves 71, 80, 81, 21, 31, 84, 86, 88, and 89 are closed.

In the process J5, the heaters 11 are driven, and the pump 12 is turned ON. For example, the liquid temperature Qt is 40°C. The liquid Q is internally circulated to flow through the pipe 1 and the pipe 5 as the liquid stream F1 and the liquid stream F5, respectively.

### [2-6. Preliminary circulation of treatment liquid]

Increasing the liquid temperature and reducing the viscosity of the liquid Q through the preliminary circulation of the liquid Q prior to the process J5 contributes to smoothly performing the internal circulation through the filters 16 in the process J5.

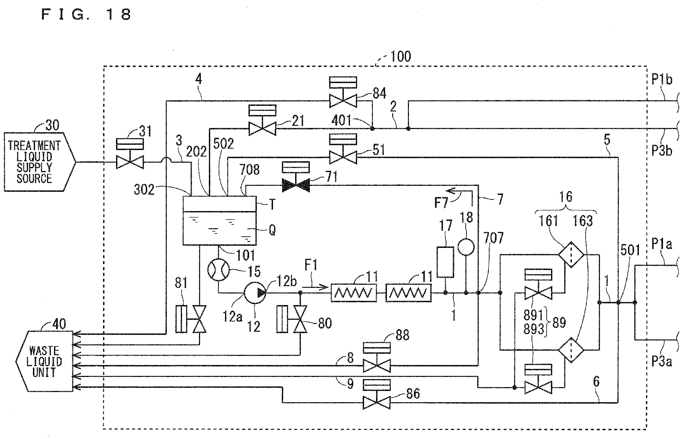

FIG. 18 illustrates a state in which a process J6 is executed. The process J6 is executed during a sixth period between the process J3 in which the treatment liquid is stored and the process J5 in which the internal circulation is performed. In the process J6, the valves 81, 21, 31, 84, 51, 86, 88, 89, and 80 are closed, and the valve 71 is opened.

In the process J6, the heaters 11 are driven, and the pump 12 is turned ON. For example, the liquid temperature Qt is set to a temperature lower than or equal to the liquid temperature Qt in the internal circulation, for example, 40°C. The liquid Q is preliminarily circulated to flow through the pipe 1 and the pipe 7 as the liquid stream F1 and the liquid stream F7, respectively.

### [2-7. Filling pump with treatment liquid]

Filling the pump 12 with the new liquid Q prior to the process J6 contributes to replacement of the liquid Q remaining in the pump 12.

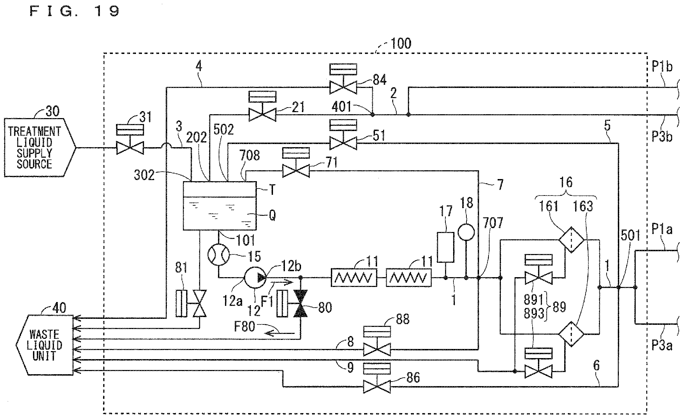

FIG. 19 illustrates a state in which a process J7 is executed. The process J7 is executed during a seventh period between the process J3 in which the treatment liquid is stored and the process J6 in which the preliminary circulation is performed. In the process J7, the valves 21, 31, 51, 71, 81, 84, 86, 88, and 89 are closed, the valve 80 is opened, and the pump 12 is driven.

In the process J7, the liquid Q flows in the pipe 1 from the inflow end 101 through the pump 12 as the liquid stream F1 without reaching the heaters 11. The liquid stream F1 flows through the valve 80 as the liquid stream F80, and flows to the waste liquid unit 40.

The process J7 allows the liquid Q stored in the storage tank T in the process J3 to be replaced with the liquid Q remaining inside the pump 12.

### [2-8. Flowchart of operations of circulation apparatus]

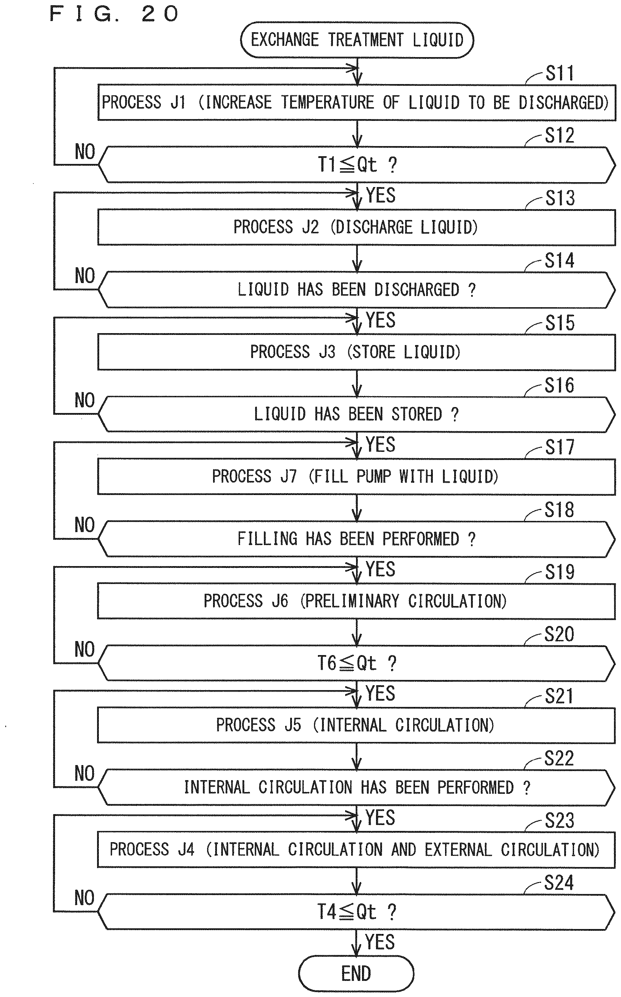

FIG. 20 is a flowchart exemplifying operations of the circulation apparatus 100 when all the processes J1, J2, J3, J4, J5, J6, and J7 are executed. Since the processes J1, J2, J3, J4, J5, J6, and J7 are used for exchanging the liquid Q that is a treatment liquid, the flowchart is titled "EXCHANGE TREATMENT LIQUID".

Steps S11, S13, S15, S17, S19, S21, and S22 are executed by opening and closing the valves 21, 31, 51, 71, 80, 84, 86, 88, 891, 893 (hereinafter also referred to as "opening and closing a valve group") using the control signal Sv by the controller U, driving (specifically, heating) and deactivating the heaters 11 using the control signal Sh, and driving and deactivating the pump 12 using the control signal Sp.

In Step S11, the process J1 is executed. Since the process J1 is executed prior to the process J2 of discharging the liquid Q from the circulation apparatus 100, Step S11 is additionally titled "(INCREASE TEMPERATURE OF LIQUID TO BE DISCHARGED)".

In Step S12, whether the liquid temperature Qt is higher than or equal to a temperature T1 is determined. The controller U makes the determination based on the data Td. When an affirmative determination is not obtained in Step S12, specifically, until the liquid temperature Qt reaches the temperature T1, Steps S11 and S12 continue to be executed. The temperature T1 is 140°C in the aforementioned example.

When the affirmative determination is obtained in Step S12, specifically, when the liquid temperature Qt reaches the temperature T1, Step S13 is executed.

In Step S13, the process J2 is executed. Since the process J2 is discharging the liquid Q from the circulation apparatus 100, Step S13 is additionally titled "(DISCHARGE LIQUID)".

Whether the liquid has been discharged is determined in Step S14. For example, a position of a liquid level of the liquid Q in the storage tank T is detected, and whether the liquid Q has been discharged is determined based on the position.

When an affirmative determination is not obtained in Step S14, specifically, for example, until a distance between the position of the liquid level of the liquid Q and the bottom of the storage tank T is shorter than or equal to a first predetermined distance, Steps S13 and S14 continue to be executed.

When the affirmative determination is obtained in Step S14, specifically, for example, when the distance between the position of the liquid level of the liquid Q and the bottom of the storage tank T is shorter than or equal to the first predetermined distance, Step S15 is executed.

The position of the liquid level of the liquid Q may be detected by a liquid sensor disposed distant at the first predetermined distance from the bottom of the storage tank T, or optically ranged from above the storage tank T and detected.

In Step S15, the process J3 is executed. Since the process J3 is storing the liquid Q in the storage tank T, Step S15 is additionally titled "(STORE LIQUID)".

Whether the liquid has been stored is determined in Step S16. The determination is made by, for example, detecting a position of a liquid level of the liquid Q in the storage tank T and determining whether the liquid Q has been stored, based on the position.

When an affirmative determination is not obtained in Step S16, specifically, for example, until a distance between the position of the liquid level of the liquid Q and the bottom of the storage tank T is longer than or equal to a second predetermined distance, Steps S15 and S16 continue to be executed.

When the affirmative determination is obtained in Step S16, specifically, for example, when the distance between the position of the liquid level of the liquid Q and the bottom of the storage tank T is longer than or equal to the second predetermined distance, Step S17 is executed.

The position of the liquid level of the liquid Q may be detected by a liquid sensor disposed distant at the second predetermined distance from the bottom of the storage tank T, or optically ranged from above the storage tank T and detected.

In Step S17, the process J7 is executed. Since the process J7 is filling the pump 12 with the new liquid Q, Step S17 is additionally titled "(FILL PUMP WITH LIQUID)".

Whether the filling has been performed is determined in Step S18. The controller U makes the determination, for example, based on whether a first predetermined time has elapsed since initial execution of Step S17. The first predetermined time is actually measured in advance, and is stored in the controller U. Every time Step S18 is executed, the controller U compares the elapsed time since initial execution of Step S17 with the first predetermined time. The determination of Step S18 is made based on a result of the comparison.

When an affirmative determination is not obtained in Step S18, specifically, for example, until the elapsed time since initial execution of Step S17 reaches the first predetermined time, Steps S17 and S18 continue to be executed.

When the affirmative determination is obtained in Step S18, specifically, for example, when the elapsed time since initial execution of Step S17 reaches the first predetermined time, Step S19 is executed.

In Step S19, the process J6 is executed. Since the preliminary circulation is performed in the process J6, Step S19 is additionally titled "(PRELIMINARY CIRCULATION)".

In Step S20, whether the liquid temperature Qt is higher than or equal to a temperature T6 is determined. The controller U makes the determination based on the data Td. When an affirmative determination is not obtained in Step S20, specifically, until the liquid temperature Qt reaches the temperature T6, Steps S19 and S20 continue to be executed. The temperature T6 is 40°C in the aforementioned example.

When the affirmative determination is obtained in Step S20, specifically, when the liquid temperature Qt reaches the temperature T6, Step S21 is executed.

In Step S21, the process J5 is executed. Since the internal circulation is performed in the process J5, Step S19 is additionally titled "(INTERNAL CIRCULATION)".

Whether the internal circulation has been performed is determined in Step S22. The next method can be employed as a first example of the determination. The controller U makes the determination, based on whether a second predetermined time has elapsed since initial execution of Step S21. The second predetermined time is actually measured in advance, and is stored in the controller U. Every time Step S22 is executed, the controller U compares the elapsed time since initial execution of Step S21 with the second predetermined time. The determination of Step S22 is made based on a result of the comparison.

When an affirmative determination is not obtained in Step S22, specifically, for example, until the elapsed time since initial execution of Step S21 reaches the second predetermined time, Steps S21 and S22 continue to be executed.

When the affirmative determination is obtained in Step S22, specifically, for example, when the elapsed time since initial execution of Step S21 reaches the second predetermined time, Step S23 is executed.

The next method can be employed as a second example of the determination in Step S22. In Step S22, whether the liquid temperature Qt is higher than or equal to a temperature T5 is determined. The controller U makes the determination based on the data Td. When an affirmative determination is not obtained in Step S22, specifically, until the liquid temperature Qt reaches the temperature T5, Steps S21 and S22 continue to be executed. The temperature T5 is 40°C in the aforementioned example.

When the affirmative determination is obtained in Step S22, specifically, when the liquid temperature Qt reaches the temperature T5, Step S23 is executed.

In Step S23, the process J4 is executed. Since the external circulation involving the internal circulation is performed in the process J4, Step S23 is additionally titled "(INTERNAL CIRCULATION AND EXTERNAL CIRCULATION)".

In Step S24, whether the liquid temperature Qt is higher than or equal to a temperature T4 is determined. The controller U makes the determination based on the data Td. When an affirmative determination is not obtained in Step S24, specifically, until the liquid temperature Qt reaches the temperature T4, Steps S23 and S24 continue to be executed. The temperature T4 is 140°C in the aforementioned example.

When the affirmative determination is obtained in Step S24, specifically, when the liquid temperature Qt reaches the temperature T4, exchange of the liquid Q ends.

### [3. Modifications]

### [3-1. Modification of process J3]

As described above, it does not matter whether the valves 21, 51, 71, 84, 86, 88, and 89 are opened or closed in the process J3. The process J3 is performed after the process J2, and the valves 21, 51, 71, 84, 86, 88, and 89 are opened in the process J2. Maintaining, in the process J3, opening the valves 21, 51, 71, 84, 86, 88, and 89 that are opened in the process J2 contributes to inhibiting operations of opening and closing these valves.

### [3-2. Modification of process J5]

Immediately after the process J4, the temperature of the external path P and/or the liquid temperature of the liquid Q that may remain in the external path P are probably approximately room temperatures. Thus, even when the external circulation involving the internal circulation is performed immediately after the end of the process J4, the liquid stream F5 flowing through the pipe 5 in which the viscosity of the liquid Q is high is formed more preferentially than the liquid stream F2 flowing through the external path P in which the viscosity of the liquid Q is low.

Thus, in the beginning of the process J5, execution of the external circulation without involving the internal circulation contributes to easily supplying the liquid Q warmed in the internal circulation to the external path P.

Specifically, the valves 21, 31, 51, 71, 80, 81, 84, 86, 88, and 89 are closed, and the valve 21 is opened in the beginning of the process J5.

The liquid Q flows from the tower P10 into the pipe 2 through the pipe P1b as the liquid stream F1b, similarly to the process J4. The liquid Q flows from the tower P30 into the pipe 2 through the pipe P3b as the liquid stream F3b. The liquid streams F1b and F3b merge in the pipe 2 to flow as the liquid stream F2. The liquid stream F2 flows from the outflow end 202 to the storage tank T through the valve 21.

Since the liquid stream F5 does not flow unlike the process J4, the liquid stream F1 flowing through the pipe 1 branches off to the liquid stream F1a flowing toward the tower P10 through the pipe P1a and the liquid stream F3a flowing toward the tower P30 through the pipe P3a.

Such external circulation without the internal circulation may temporarily reduce the liquid temperature Qt. When the liquid temperature Qt obtained from the data Td is the temperature T5, opening the valve 51 forms the liquid stream F5 to cause the internal circulation to be involved in the external circulation.

Such a modification of the process J5 can be described as adding a process of performing the external circulation without involving the internal circulation before the process J5.

### [3-3. Modification of process J2]

In the description of the process J2, a case where the pump 12 is deactivated is exemplified. When a magnetic levitation centrifugal pump is not employed as the pump 12, the liquid in the pump 12 can be discharged. In the process J2, opening the valve 80 and driving the pump 12 discharge the liquid Q from the inflow end 101 to the outlet 12b.

A part or the entirety of the constituents in the embodiment and the modifications can be combined as necessary unless any contradiction occurs.

### EXPLANATION OF REFERENCE SIGNS

1 pipe (first pipe)
2 pipe (second pipe)
3 pipe (third pipe)
4 pipe (fourth pipe)
5 pipe (fifth pipe)
6 pipe (sixth pipe)
7 pipe (seventh pipe)
8 pipe (eighth pipe)
9 pipe (eighth pipe)
11 heater
12 pump
12a inlet
12b outlet
16 filter
21 valve (second valve)
30 treatment liquid supply source (liquid supply source)
31 valve (third valve)
40 waste liquid unit (outside)
51 valve (fifth valve)
71 valve (seventh valve)
80 valve (tenth valve)
81 valve (first valve)
84 valve (fourth valve)
86 valve (sixth valve)
88 valve (eighth valve)
89 valve (eighth valve)
100 circulation apparatus
101 inflow end (first inflow end)
202 outflow end (second outflow end)
302 outflow end (third outflow end)
502 outflow end (fifth outflow end)
708 outflow end (seventh outflow end)
P external path
Q liquid
T storage tank
U controller

## Claims

1. A method of controlling a circulation apparatus that supplies and collects a liquid to and from an external path,
wherein the circulation apparatus includes:
a storage tank in which the liquid is an object to be stored;
a first pipe including a first inflow end into which the liquid flows from the storage tank, the first pipe being used for supplying the liquid;
a first valve connected to the storage tank and controlling discharge of the liquid from the storage tank to an outside of the circulation apparatus;
a pump in which the liquid is an object is to be expelled, the pump being disposed in the first pipe and including an inlet connected to the first inflow end and an outlet;
a heater in which the liquid is an object is to be heated, the heater being disposed in the first pipe and connected to the outlet;
a second pipe including a second outflow end from which the liquid flows into the storage tank, the second pipe being used for collecting the liquid;
a second valve disposed in the second pipe and controlling an outflow of the liquid from the second outflow end to the storage tank;
a third pipe including a third outflow end from which the liquid flows into the storage tank, the third pipe being a path of the liquid to be stored in the storage tank from a liquid supply source at the outside of the circulation apparatus;
a third valve disposed in the third pipe and controlling an outflow of the liquid from the third outflow end to the storage tank;
a fourth pipe connected to the second pipe on an opposite side of the second outflow end with respect to the second valve, the fourth pipe being a path of the liquid to be discharged from the second pipe to the outside of the circulation apparatus; and
a fourth valve disposed in the fourth pipe and controlling the discharge of the liquid,
the method comprising;
a first process of closing the first valve, the third valve, and the fourth valve, opening the second valve, driving the heater to increase a temperature of the liquid, and driving the pump, the first process being performed during a first period;
a second process of deactivating the pump, opening the first valve, the second valve, and the fourth valve, and closing the third valve, the second process being performed during a second period after the first period;
a third process of deactivating the pump, closing the first valve, and opening the third valve, the third process being performed during a third period after the second period; and
a fourth process of closing the first valve, the third valve, and the fourth valve, opening the second valve, driving the heater to increase the temperature of the liquid, and driving the pump, the fourth process being performed during a fourth period after the third period.

2. The method according to claim 1,
wherein the circulation apparatus further includes:
a fifth pipe including a fifth outflow end from which the liquid flows into the storage tank, the fifth pipe being connected to the first pipe on an opposite side of the pump with respect to the heater;
a fifth valve disposed in the fifth pipe and controlling an outflow of the liquid from the fifth outflow end to the storage tank;
a sixth pipe connected to the fifth pipe on an opposite side of the fifth outflow end with respect to the fifth valve, the sixth pipe being a path of the liquid to be discharged from the fifth pipe to the outside of the circulation apparatus; and
a sixth valve disposed in the sixth pipe and controlling the discharge of the liquid, and
in the method:
the fifth valve and the sixth valve are closed in the first process;
the fifth valve and the sixth valve are opened in the second process; and
the fifth valve is opened and the sixth valve is closed in the fourth process,
the method further comprising
a fifth process of closing the first valve, the second valve, the third valve, the fourth valve, and the sixth valve, opening the fifth valve, driving the heater to increase the temperature of the liquid, and driving the pump, the fifth process being performed during a fifth period between the third period and the fourth period.

3. The method according to claim 2,
wherein the circulation apparatus further includes:
a filter disposed in the first pipe between the heater, and the fifth and sixth pipes;
a seventh pipe including a seventh outflow end from which the liquid flows into the storage tank, the seventh pipe being connected to the first pipe between the heater and the filter;
a seventh valve disposed in the seventh pipe and controlling an outflow of the liquid from the seventh outflow end to the storage tank;
an eighth pipe connected to the seventh pipe on an opposite side of the seventh outflow end with respect to the seventh valve, the eighth pipe being a path of the liquid to be discharged from the seventh pipe to the outside of the circulation apparatus;
an eighth valve disposed in the eighth pipe and controlling the discharge of the liquid;
a ninth pipe connected to the filter, the ninth pipe being a path of the liquid to be discharged from the filter to the outside of the circulation apparatus; and
a ninth valve disposed in the ninth pipe and controlling the discharge of the liquid, and
in the method:
the seventh valve, the eighth valve, and the ninth valve are closed in the first process;
the seventh valve, the eighth valve, and the ninth valve are opened in the second process; and
the seventh valve, the eighth valve, and the ninth valve are closed in the fourth process and the fifth process,
the method further comprising
a sixth process of closing the first valve, the second valve, the third valve, the fourth valve, the fifth valve, the sixth valve, the eighth valve, and the ninth valve, opening the seventh valve, driving the heater to increase the temperature of the liquid lower than or equal to a temperature of the liquid during the fifth period, and driving the pump, the sixth process being performed during a sixth period between the third period and the fifth period.

4. The method according to claim 3,
wherein the circulation apparatus further includes
a tenth valve connected to the outlet and controlling the discharge of the liquid to the outside of the circulation apparatus, and
in the method, the tenth valve is closed in the first process, the second process, the third process, the fourth process, the fifth process, and the sixth process,
the method further comprising
a seventh process of closing the first valve, the second valve, the third valve, the fourth valve, the fifth valve, the sixth valve, the seventh valve, the eighth valve, and the ninth valve, opening the tenth valve, and driving the pump, the seventh process being performed during a seventh period between the third period and the sixth period.

5. A circulation apparatus that supplies and collects a liquid to and from an external path, the circulation apparatus comprising:
a storage tank in which the liquid is an object to be stored;
a first pipe including a first inflow end into which the liquid flows from the storage tank, the first pipe being used for supplying the liquid;
a first valve connected to the storage tank and controlling discharge of the liquid from the storage tank to an outside of the circulation apparatus;
a pump in which the liquid is an object is to be expelled, the pump being disposed in the first pipe and including an inlet connected to the first inflow end and an outlet;
a heater in which the liquid is an object is to be heated, the heater being disposed in the first pipe and connected to the outlet;
a second pipe including a second outflow end from which the liquid flows into the storage tank, the second pipe being used for collecting the liquid;
a second valve disposed in the second pipe and controlling an outflow of the liquid from the second outflow end to the storage tank;
a third pipe including a third outflow end from which the liquid flows into the storage tank, the third pipe being a path of the liquid to be stored in the storage tank from a liquid supply source at the outside of the circulation apparatus;
a third valve disposed in the third pipe and controlling an outflow of the liquid from the third outflow end to the storage tank;
a fourth pipe connected to the second pipe on an opposite side of the second outflow end with respect to the second valve, the fourth pipe being a path of the liquid to be discharged from the second pipe to the outside of the circulation apparatus;
a fourth valve disposed in the fourth pipe and controlling the discharge of the liquid; and
a controller controlling the first valve, the second valve, the third valve, the fourth valve, the pump, and the heater, wherein
during a first period, the controller closes the first valve, the third valve, and the fourth valve, opens the second valve, drives the heater to increase a temperature of the liquid, and drives the pump,
during a second period after the first period, the controller deactivates the pump, opens the first valve, the second valve, and the fourth valve, and closes the third valve,
during a third period after the second period, the controller deactivates the pump, closes the first valve, and opens the third valve, and
during a fourth period after the third period, the controller closes the first valve, the third valve, and the fourth valve, opens the second valve, drives the heater to increase the temperature of the liquid, and drives the pump.

6. The circulation apparatus according to claim 5, further comprising:
a fifth pipe including a fifth outflow end from which the liquid flows into the storage tank, the fifth pipe being connected to the first pipe on an opposite side of the pump with respect to the heater;
a fifth valve disposed in the fifth pipe and controlling an outflow of the liquid from the fifth outflow end to the storage tank;
a sixth pipe connected to the fifth pipe on an opposite side of the fifth outflow end with respect to the fifth valve, the sixth pipe being a path of the liquid to be discharged from the fifth pipe to the outside of the circulation apparatus; and
a sixth valve disposed in the sixth pipe and controlling the discharge of the liquid, wherein
the controller closes the fifth valve and the sixth valve during the first period,
the controller opens the fifth valve and the sixth valve during the second period,
the controller opens the fifth valve and closes the sixth valve during the fourth period, and
during a fifth period between the third period and the fourth period, the controller closes the first valve, the second valve, the third valve, the fourth valve, and the sixth valve, opens the fifth valve, drives the heater to increase the temperature of the liquid, and drives the pump.

7. The circulation apparatus according to claim 6, further comprising:
a filter disposed in the first pipe between the heater, and the fifth and sixth pipes;
a seventh pipe including a seventh outflow end from which the liquid flows into the storage tank, the seventh pipe being connected to the first pipe between the heater and the filter;
a seventh valve disposed in the seventh pipe and controlling an outflow of the liquid from the seventh outflow end to the storage tank;
an eighth pipe connected to the seventh pipe on an opposite side of the seventh outflow end with respect to the seventh valve, the eighth pipe being a path of the liquid to be discharged from the seventh pipe to the outside of the circulation apparatus;
an eighth valve disposed in the eighth pipe and controlling the discharge of the liquid;
a ninth pipe connected to the filter, the ninth pipe being a path of the liquid to be discharged from the filter to the outside of the circulation apparatus; and
a ninth valve disposed in the ninth pipe and controlling the discharge of the liquid, wherein
the seventh valve, the eighth valve, and the ninth valve are closed during the first period,
the seventh valve, the eighth valve, and the ninth valve are opened during the second period,
the seventh valve, the eighth valve, and the ninth valve are closed during the fourth period and the fifth period, and
during a sixth period between the third period and the fifth period, the first valve, the second valve, the third valve, the fourth valve, the fifth valve, the sixth valve, the eighth valve, and the ninth valve are closed, the seventh valve is opened, the heater is driven to increase the temperature of the liquid lower than or equal to a temperature of the liquid during the fifth period, and the pump is driven.

8. The circulation apparatus according to claim 7, further comprising
a tenth valve connected to the outlet and controlling the discharge of the liquid to the outside of the circulation apparatus, wherein
the tenth valve is closed during the first period, the second period, the third period, the fourth period, the fifth period, and the sixth period, and
during a seventh period between the third period and the sixth period, the first valve, the second valve, the third valve, the fourth valve, the fifth valve, the sixth valve, the seventh valve, the eighth valve, and the ninth valve are closed, the tenth valve is opened, and the pump is driven.
